(19) Europäisches Patentamt
European Patent Office
Office européen des brevets

(11) **EP 2 426 556 B1**

(12) **FASCICULE DE BREVET EUROPEEN**

(45) Date de publication et mention
de la délivrance du brevet:
**07.10.2015 Bulletin 2015/41**

(51) Int Cl.:
***G03F 7/00*** *(2006.01)*

(21) Numéro de dépôt: **11179917.7**

(22) Date de dépôt: **02.09.2011**

(54) **Moule pour la lithographie par nano-impression thermique, son procédé de preparation, et procédé de nano-impression thermique le mettant en oeuvre**

Form für thermische Nanoprägelithographie, ihr Herstellungsverfahren und sie einsetzendes thermisches Nanoprägelithographie-Verfahren

Mould for lithography by thermal nanoprinting, method for preparing same and thermal nanoprinting method using said mould

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.09.2010 FR 1057112**

(43) Date de publication de la demande:
**07.03.2012 Bulletin 2012/10**

(73) Titulaire: **Commissariat à l'Énergie Atomique et aux Énergies Alternatives**
**75015 Paris (FR)**

(72) Inventeurs:
• **Landis, Stefan**
**38500 VOIRON (FR)**
• **Nicoletti, Sergio**
**38650 SINARD (FR)**

(74) Mandataire: **Augarde, Eric et al**
**Brevalex**
**56 Boulevard de l'Embouchure,**
**Bât. B**
**B.P. 27519**
**31075 Toulouse Cedex 2 (FR)**

(56) Documents cités:
WO-A1-2004/058479    WO-A1-2004/114017
US-A1- 2006 279 022    US-A1- 2010 072 665

# Description

## DOMAINE TECHNIQUE

L'invention concerne un moule pour la lithographie par nano-impression thermique ou nano-impression assistée thermiquement.

L'invention concerne, en outre, un procédé de préparation de ce moule.

L'invention concerne, enfin, un procédé de lithographie par nano-impression thermique qui met en oeuvre ce moule.

## ÉTAT DE LA TECHNIQUE ANTÉRIEURE

Le domaine technique de l'invention peut être défini de manière générale comme celui de la lithographie par nano-impression (« Nano Imprint Lithography » ou « NIL » en anglais).

La lithographie par nano-impression combine les petites dimensions critiques de la lithographie par faisceaux d'électrons et le rendement élevé de la technologie optique (scanner ou stepper), et constitue donc une technique rentable dans le cadre de la mise en oeuvre d'une lithographie haute définition.

Il existe de nombreux types de lithographie par nano-impression mais les plus importants sont la lithographie par nano-impression thermique et la lithographie par nano-impression assistée par UV.

La lithographie par nano-impression thermique est la plus ancienne de ces techniques et a été développée par l'équipe du Professeur Stephen Chou en 1995.

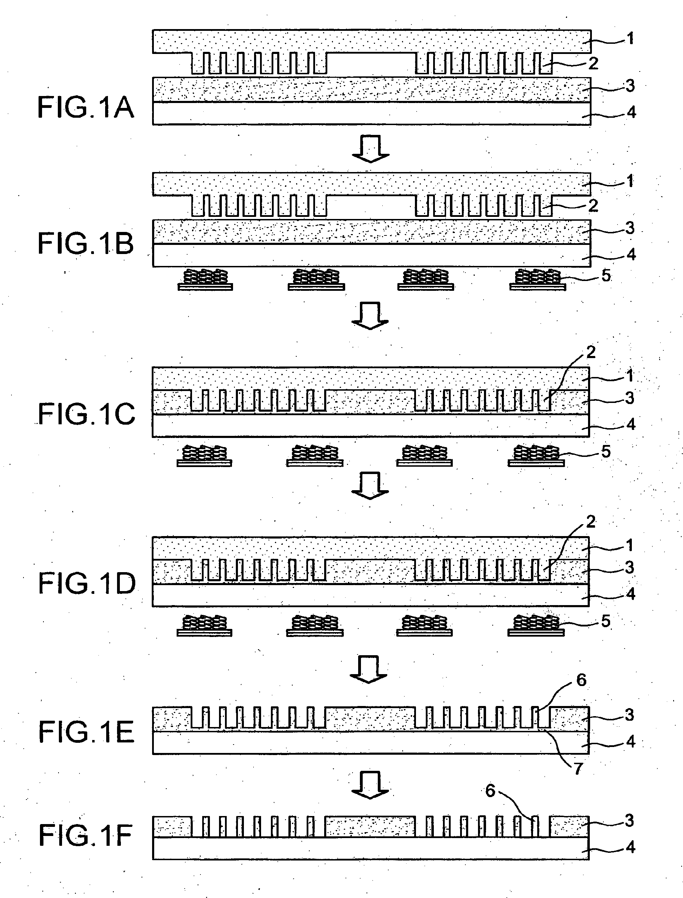

La technique de nano-impression thermique ou de nano-impression assistée thermiquement, est décrite sur les figures 1A à 1F. Elle met en oeuvre (Figure 1A) d'une part un moule rigide (1) généralement en silicium ou en un de ses dérivés ($SiO_2$, nitrure de silicium...) ; en polymère ; ou en nickel, comportant en relief les structures, motifs à dupliquer (2) et d'autre part une couche de matériau (3) tel qu'un polymère thermoplastique ou une résine organique déposée sur le substrat (4) à structurer. Le moule est réalisé par des techniques classiques de lithographie ou de gravure.

La couche de matériau (3) est chauffée à une température supérieure à la température de transition vitreuse ou à la température de fusion du matériau, au moyen d'éléments chauffants (5) (Figure 1B).

Le moule (1) et l'échantillon à imprimer sont ensuite mis en contact, et une pression appliquée sur la face arrière du moule (1) permet de presser celui-ci dans la couche de matériau chauffée (3) (Figure 1C).

A l'issue de ce pressage à chaud, on abaisse la température du matériau en-dessous de la température de transition vitreuse ou de la température de fusion du matériau, par exemple en inactivant les éléments chauffants (5), pour figer les structures imprimées dans la couche de matériau (Figure 1D).

On procède ensuite au démoulage, c'est-à-dire à la séparation du moule (1) du substrat qui porte une couche de matériau (3) imprimé avec des motifs imprimés (6) (Figure 1E).

Enfin, on réalise l'ouverture de l'épaisseur résiduelle (7) qui reste sous les motifs imprimés (6) (Figure 1F).

A l'issue du procédé de nano-impression thermique, les motifs du moule sont reproduits dans la couche de matériau tel qu'un polymère et peuvent servir de masque de gravure.

On peut ainsi réaliser des motifs de quelques nanomètres à plusieurs microns dans le matériau tel qu'un polymère et par la suite les transférer sur le substrat.

Après plus de dix années de développement, cette technique de lithographie est d'ores et déjà utilisée dans certains secteurs industriels.

Dans la nano-impression assistée par UV (« FlashImprint Lithography » ou « Photo NanoImprint Lithography » en anglais), un moule transparent, par exemple en quartz, est pressé dans une solution de monomères ou un prépolymère à température ambiante, sous une faible pression. Ensuite les motifs sont figés par photopolymérisation des monomères ou réticulation sous l'effet d'un rayonnement UV. Cette technique connaît actuellement un important développement du fait de la possibilité d'alignement entre différents niveaux avec le moule transparent.

Dans toutes les techniques de nano-impression, la fabrication des moules est une étape critique, puisque la résolution et le rendement de production en nano-impression et en nanomoulage dépendent largement de la qualité du moule utilisé.

Dans la technique de nano-impression thermique, le moule est fabriqué à partir d'un substrat massif en silicium sur lequel des motifs sont fabriqués par les technologies standard de lithographie (optique, électronique, ou aux rayons X...) et de gravure. L'épaisseur de ces moules est généralement dans une plage comprise entre quelques centaines de micromètres et quelques millimètres pour plusieurs raisons :

-   d'une part pour permettre leur manipulation et leur positionnement sur les substrats,

-   d'autre part, parce que la qualité de surface du moule, réalisé avec des substrats dont l'épaisseur est standard, avec des procédés classiques de micro et nano-fabrication est ainsi garantie et comparable à celle des substrats sur lesquels l'impression sera réalisée.

Comme on peut le constater sur le schéma du procédé de nano-impression thermique de la figure 1, une étape de mise en température dudit moule ainsi que du matériau à imprimer et du substrat le supportant est nécessaire (Figure 1B).

Typiquement, les températures mises en jeu sont comprises entre 60°C et 250°C. Elles correspondent avantageusement aux températures de transition vitreuse (Tg) ou de fusion (Tf) du matériau à imprimer.

Pour pouvoir assurer une stabilité mécanique suffisante pour démouler, c'est-à-dire pour assurer la séparation du moule du matériau à imprimer, il est alors nécessaire de refroidir l'ensemble en-deçà de la Tg ou de la Tf. Le temps nécessaire pour réaliser ce cycle de température peut atteindre plusieurs minutes voire dizaines de minutes. Compte tenu de la durée des autres opérations associées à la mise en oeuvre de ce procédé, à savoir le couchage du matériau tel qu'une résine, la mise en contact et le pressage, le démoulage, la durée de ce cycle de température limite par conséquent le rendement de ce genre de technologie.

En outre, avec les moules en silicium qui sont généralement mis en oeuvre dans la technique de nano-impression thermique, l'alignement entre les motifs sur le moule et des motifs déjà réalisés sur la plaque à imprimer est possible mais très difficile.

En effet, le moule en silicium n'étant pas transparent aux longueurs d'ondes visibles, l'alignement nécessite l'utilisation d'une caméra dite à deux objectifs.

Par ailleurs, cet alignement ne peut pas être réalisé lorsque le moule et la plaque à presser sont très proches, car il faut pouvoir positionner la caméra. L'alignement est donc nécessairement effectué lorsque l'écart entre le moule et la plaque à presser est supérieur à quelques centimètres. Cette contrainte limite donc la capacité d'alignement.

Typiquement, on peut espérer obtenir une précision de l'alignement se situant dans une gamme de quelques centaines de nanomètres, ce qui est très insuffisant pour de nombreuses applications. Par conséquent, l'utilisation de moules en silicium limite le champ d'application de la technologie de nano-impression thermique.

Les moules fabriqués à partir d'un substrat en quartz donnent la possibilité d'aligner les structures à imprimer avec les structures existantes sur la surface de la plaque avant de réticuler le polymère par exposition UV. Mais, la fabrication du moule reste alors problématique car, d'une part les substrats en quartz sont plus chers et plus difficiles à structurer et d'autre part, la maîtrise des procédés de fabrication n'est pas aussi avancée que pour les substrats tels que des plaquettes (« wafers » en langue anglaise) en silicium.

Une autre limitation importante de la technologie courante (c'est-à-dire avec moule en silicium) de nano-impression thermique provient du fait que l'ensemble constitué par le moule, le matériau à imprimer, et la plaque est uniformément chauffé à une température comprise par exemple entre 60°C et 250°C, indépendamment de la répartition, de la géométrie, et de la taille des motifs à imprimer.

Or la vitesse de pénétration d'un motif du moule dans la résine est directement reliée à la taille de ce motif et à la viscosité du matériau pressé.

Un motif plus large s'enfoncera moins vite qu'un motif fin, car la température étant identique dans toute la couche de résine, sa viscosité est identique également dans tout le film.

Ces différences entre les vitesses d'enfoncement, de pénétration, des différents motifs vont générer des contraintes mécaniques dans le moule, et donc des déformations qui vont se manifester par des épaisseurs résiduelles différentes suivant les motifs.

Ces différences d'épaisseurs résiduelles sont définies par le terme « distribution d'épaisseur résiduelle ».

Les problèmes dus aux différences de vitesses d'enfoncement et aux différences d'épaisseurs résiduelles constituent une limitation importante de la technologie de nano-impression thermique car les procédés ultérieurs de gravure de l'épaisseur résiduelle peuvent alors modifier les dimensions finales des objets obtenus par rapport aux dimensions initialement présentes sur le moule.

Le document WO2004058479 A décrit un moule chauffant pour la lithographie par nano-impression thermique (voir Figure 7 de ce document).

Le document WO-A1-2004/114017 décrit un moule 12 pour la lithographie par nano-impression thermique qui comprend une région de surface 14 qui comporte les motifs à imprimer ((Figures 1A à 1D de ce document).

Le corps du moule est en un matériau électriquement conducteur 16 de faible conductivité, par exemple en un semi-conducteur tel que le Si ou le SiC ou un métal.

Lorsque le moule est pressé contre la masse de polymère 10, on fait passer simultanément un courant électrique 18 dans le corps du moule 12 où de la chaleur est ainsi générée par effet Joule et cette chaleur est transmise par conduction à la région de surface 14.

Le passage du courant 19 peut par exemple être provoqué par application d'une différence de potentiel ou par exposition à un champ magnétique ou électromagnétique variable.

Sur les Figures 2A à 2D de ce document, le corps de moule comprend une couche de matériau électriquement conducteur 16 qui supporte la région de surface 14 qui comporte les motifs à imprimer.

Dans ce document, le chauffage est uniforme sur toute la surface du moule car la couche chauffante subjacente aux éléments à imprimer est continue et au moins aussi étendue que la zone d'impression. De ce fait, avec le moule de ce document, il n'existe pas de possibilité d'ajuster et d'optimiser localement la température.

Le moule de ce document n'apporte aucune solution aux problèmes de différences de vitesses d'enfoncement et de différences d'épaisseurs résiduelles.

Il existe donc, au regard de ce qui précède, un besoin pour des moules pour la lithographie par nano-impression assistée thermiquement, ou plus simplement pour la nano-impression thermique, qui permettent de résoudre les problèmes de différences de vitesses d'enfoncement et de différences d'épaisseurs résiduelles des moules de l'art antérieur.

Il existe, en outre, un besoin pour des moules pour la lithographie par nano-impression assistée thermiquement ou plus simplement pour la nano-impression thermique, qui nécessitent un faible apport d'énergie pour atteindre la température de travail, qui présentent une faible inertie thermique et qui permettent de réaliser des cycles de chauffage, montée en température, refroidissement, descente en température, dont la durée soit la plus courte possible.

Il existe, aussi un besoin pour des moules pour la nano-impression thermique qui soient faciles à fabriquer, faciles à manipuler, de faible volume, qui présentent une excellente qualité de surface et une excellente résolution.

## EXPOSÉ DE L'INVENTION

Le but de la présente invention est de fournir un moule pour la lithographie par nano-impression thermique qui réponde entre autres aux besoins énumérés plus haut.

Le but de la présente invention est encore de fournir un moule pour la lithographie par nano-impression thermique qui ne présente pas les inconvénients, défauts, limitations et désavantages des moules de l'art antérieur et qui résolve les problèmes des moules de l'art antérieur.

Ce but, et d'autres encore, sont atteints, conformément à l'invention, dans un premier mode de réalisation de celle-ci, par un moule chauffant pour la lithographie par nano-impression thermique comprenant :

- un substrat (21) comportant une première surface principale (22) et une seconde surface principale (23), ladite première surface principale (22) étant éventuellement au moins en partie recouverte par une première membrane (29), et une seconde membrane électriquement et thermiquement isolante (30) reposant par une première de ses faces (31) sur ladite seconde surface principale (23) et recouvrant au moins en partie ladite seconde surface principale (23) ;

- éventuellement, une couche (33) thermiquement conductrice et de support mécanique de la seconde membrane (30) sur au moins une partie de ladite première face (31) de la seconde membrane (30) et au-dessus dudit substrat ;

- éventuellement, une couche isolante sous ladite couche (33) thermiquement conductrice et de support mécanique ;

- des moyens de chauffage résistifs (34) sur l'autre des faces (35) de ladite seconde membrane (30) dans une zone de ladite seconde membrane (30) ;

- une couche électriquement et thermiquement isolante (36) qui recouvre lesdits moyens de chauffage (34) et au moins partiellement ladite seconde membrane (30) ;

- des motifs à imprimer (37) sur ladite couche électriquement et thermiquement isolante (36) dans une zone de la surface de ladite couche électriquement et thermiquement isolante (36) au-dessus desdits moyens de chauffage (34) ;

- des moyens de captage pour capter l'énergie électromagnétique d'un champ électromagnétique variable émis par une source située à l'extérieur du moule, lesdits moyens de captage étant reliés auxdits moyens de chauffage résistif (34) dans lesquels ladite énergie est dissipée.

Ce but, et d'autres encore, sont atteints, conformément à l'invention, dans un deuxième mode de réalisation de celle-ci, par un moule chauffant pour la lithographie par nano-impression thermique comprenant :

- un substrat (21) comportant une première surface principale (22) et une seconde surface principale (23), et une cavité traversante (24) s'étendant depuis un premier orifice (27) dans la première surface principale (22) jusqu'à un second orifice (28) dans la seconde surface principale (23), ladite première surface principale (22) étant éventuellement au moins en partie recouverte par une première membrane (29) obturant totalement ou en partie ou bien laissant libre ledit premier orifice (27), et ledit second orifice (28) étant totalement obturé par une seconde membrane électriquement et thermiquement isolante (30) reposant par une première de ses faces (31) sur ladite seconde surface principale (23) et recouvrant au moins en partie ladite seconde surface (23) ;

- éventuellement, une couche (33) thermiquement conductrice et de support mécanique de la seconde membrane (30) sur ladite première face (31) de la seconde membrane (30) au-dessus (32) dudit second orifice (28) ;

- éventuellement, une couche isolante sous ladite couche (33) thermiquement conductrice et de support mécanique ;

- des moyens de chauffage résistifs (34) sur l'autre des faces (35) de ladite seconde membrane (30) dans une zone de ladite seconde membrane (30) au-dessus dudit second orifice (28) ;

- une couche électriquement et thermiquement isolante (36) qui recouvre lesdits moyens de chauffage (34) et au moins partiellement ladite seconde membrane (30) ;

- des motifs à imprimer (37) sur ladite couche électriquement et thermiquement isolante (36) dans une zone de ladite couche électriquement et thermiquement isolante (36) au-dessus dudit second orifice (28) ;

- des moyens de captage pour capter l'énergie électromagnétique d'un champ électromagnétique variable émis par une source située à l'extérieur du moule, lesdits moyens de captage étant reliés auxdits moyens de chauffage résistifs (34) dans lesquels ladite énergie est dissipée.

Le moule selon l'invention aussi bien dans son premier mode de réalisation que dans son second mode de réalisation, n'a jamais été ni décrit, ni suggéré dans l'art antérieur.

Le moule selon l'invention répond entre autres aux besoins énumérés plus haut pour des moules pour la lithographie par nano-impression thermique, répond à tous les critères et exigences pour ce type de moule, ne présente pas les inconvénients, défauts, limitations et désavantages des moules de l'art antérieur et apporte une solution aux problèmes posés par les moules de l'art antérieur.

Le moule selon l'invention aussi bien dans le premier mode de réalisation que dans le second mode de réalisation, présente en tant que première caractéristique principale des moyens de captage pour capter l'énergie électromagnétique d'un champ électromagnétique variable émis par une source située à l'extérieur du moule, ces moyens de captage étant reliés auxdits moyens de chauffage résistifs dans lesquels ladite énergie est dissipée.

Les moyens de chauffage résistifs du moule selon l'invention reçoivent l'énergie qui leur est nécessaire sans qu'ils soient reliés, par des moyens tels que des câbles électriques, à des dispositifs d'alimentation en énergie extérieurs au moule. De ce fait, le moule selon l'invention ne comprend pas de connectiques électriques, interconnexions, passantes entre le moule et la tête d'impression.

L'intégration des moules selon l'invention dans des équipements déjà existant se trouve ainsi grandement facilitée. La fabrication des moules selon l'invention est également beaucoup plus simple, plus courte et moins coûteuse.

Le moule selon l'invention présente, en tant que deuxième caractéristique principale des moyens de chauffage, intégrés sur une membrane, que l'on peut dans le second mode de réalisation qualifier de « membrane suspendue » qui est destinée à recevoir des structures, motifs qui seront par la suite imprimés dans une couche de matériau tel qu'un polymère ou une résine thermoplastique.

Ces structures, motifs, ont des tailles qui peuvent varier de quelques nanomètres à plusieurs micromètres.

Le moule selon l'invention, du fait notamment qu'il présente un faible volume et que son volume total est réduit et limité à l'ensemble membrane, élément chauffant et nano ou microstructures nécessite un apport d'énergie réduit pour atteindre la température de travail. Le temps de chauffe et de refroidissement s'en trouve également significativement réduit, ce qui améliore grandement la rapidité du procédé, sa capacité, son rendement, et son coût.

Typiquement, la durée d'un cycle de chauffe (pour atteindre une température comprise par exemple entre 100°C et 200°C) et de refroidissement (pour redescendre par exemple jusqu'à 30°C) passe de quelques minutes, voire quelques dizaines de minutes à quelques secondes.

Comme on l'indique plus bas, le moule comprend généralement plusieurs groupes de motifs à imprimer qui diffèrent de par leur forme et/ou leur taille.

Du fait que les éléments chauffants du moule selon l'invention peuvent être adaptés à chaque groupe de motifs en modifiant notamment la taille et/ou la forme et/ou la densité des éléments chauffants en fonction de la forme et/ou de la taille des motifs à imprimer de chacun des groupes, cela permet de chauffer à des températures différentes les groupes de motifs et donc d'ajuster localement la viscosité de la couche, du film de polymère, résine à imprimer afin d'assurer un enfoncement homogène du moule dans la résine ou polymère.

Ainsi, par exemple, on pourra chauffer les motifs « fins » à une température plus faible que les motifs « larges » et les motifs fins et les motifs larges pourront s'enfoncer dans la résine à la même Vitesse, le moule sera donc soumis à moins de déformations et la distribution d'épaisseur résiduelle sera plus homogène.

C'est précisément le mode d'alimentation simplifié en énergie des moyens de chauffage du moule selon l'invention, qui en supprimant tout câblage entre le moule et l'extérieur de celui-ci, permet d'ajuster précisément, individuellement, la température de chacun des éléments chauffants alors que cela aurait été impossible dans les modes de l'art antérieur eu égard au nombre de connexions et passages traversants qui auraient été nécessaires.

Avantageusement, lesdites première (22) et seconde (23) surfaces principales peuvent être planes et parallèles.

Avantageusement, lesdites première (22) et seconde (23) surfaces principales peuvent être horizontales, et la première surface principale (22) peut être alors définie comme une surface inférieure et la seconde surface principale (23) peut être alors définie comme une surface supérieure.

Avantageusement, le moule selon l'invention peut comprendre en outre des marques de positionnement, alignement (39, 40).

Avantageusement, lesdites marques d'alignement sont situées dans la seconde couche de membrane (30) et/ou dans la couche électriquement et thermiquement isolante (36) et/ou sur ladite couche électriquement et thermiquement isolante (36) au voisinage desdits motifs à imprimer (37).

Ces marques d'alignement, positionnement (39), permettent un alignement, positionnement fin des motifs à imprimer (37), supportés par le moule par rapport à un niveau de référence et à des motifs déjà réalisés sur l'échantillon à imprimer.

Un alignement fin, à savoir avec un écart inférieur à 100 nm est ainsi rendu possible, qui n'était pas jusqu'alors disponible avec les moules massifs en silicium couramment utilisés dans la lithographie par nano-impression thermique.

Avantageusement, lesdits moyens pour capter l'énergie électromagnétique sont constitués par un ou plusieurs récepteur(s) de radiofréquences ou antenne(s) de captage de radiofréquences ou RF.

Dans une première forme de réalisation, des moyens de chauffage résistifs et des moyens de captage, lesdits moyens de chauffage résistifs et lesdits moyens de captage peuvent être distincts, séparés, différents, éloignés et reliés par des moyens d'acheminement de l'énergie.

Ainsi, lesdits moyens de captage peuvent être situés dans un même plan que lesdits moyens de chauffage résistifs, sur l'autre des faces (35) de ladite seconde membrane (30) et en dehors de la zone où sont situés lesdits moyens de chauffage résistifs, ou bien lesdits moyens de captage peuvent être situés dans un plan différent desdits moyens de chauffage résistifs.

Dans une deuxième forme de réalisation, lesdits moyens de chauffage résistifs et lesdits moyens de captage peuvent être confondus.

Avantageusement, lesdits moyens de chauffage résistifs et lesdits moyens de captage lorsqu'ils sont confondus se présentent sous la forme d'un ou plusieurs motif(s) de chauffage et de captage tels qu'une ou plusieurs boucle(s) de captage résistive(s).

Il est à noter que dans ces moyens de captage et de chauffage confondus, le captage provient de la forme du motif, tel qu'une boucle, et le chauffage provient des propriétés de transport des motifs.

Ces propriétés de captage et de chauffage sont bien sûr, en outre, influencées par la dimension de ces motifs.

Avantageusement, les moyens de chauffage résistifs, ou les moyens de chauffage résistifs et les moyens de captage confondus comprennent plusieurs éléments chauffants discrets, distincts, séparés les uns des autres par ladite couche électriquement et thermiquement isolante (36) et/ou la seconde membrane (30), et la forme et/ou la taille et/ou la densité desdits éléments chauffants est (sont) choisie(s) de manière à ajuster, régler localement la température de chauffage de la surface de ladite couche (36) et des motifs à imprimer (37) se trouvant sur cette surface.

Avantageusement, les motifs à imprimer (37) comprennent des motifs à imprimer de tailles différentes se trouvant sur des zones différentes de la surface de la couche (36), et la forme et/ou la taille et/ou la densité des éléments chauffants (34) est (sont) choisie(s) de manière à ce que les zones de la surface de la couche (36) sur lesquelles se trouvent des motifs à imprimer de relativement plus grande taille soient chauffées à une température plus élevée que les zones de la surface de la couche (36) sur lesquelles se trouvent des motifs à imprimer de relativement plus petite taille.

Avantageusement, lesdits moyens de captage sont en un matériau très peu résistif choisi de préférence parmi Cu, Al, Pt, Ta, TiN et tous les autres matériaux conducteurs compatibles avec les procédés de micro et de nanofabrication .

Par matériau très peu résistif, on entend généralement que sa résistivité est de l'ordre de 1 à 10 $\mu$Ohms.cm. Une telle résistivité correspond généralement à la conductivité moyenne d'un métal.

En général, les moyens de captage/chauffage confondus et les moyens de chauffage sont réalisés en un même matériau conducteur, et on change la section du conducteur pour dissiper ou non la chaleur.

Avantageusement, le substrat peut être en un matériau choisi parmi les matériaux compatibles avec les procédés, technologies de micro et nanofabrication tels que le silicium, l'oxyde de silicium, le nitrure de silicium le germanium, le saphir, le GaAs, et de manière générale, tous les matériaux compatibles avec les technologies dédiées à la micro-électronique et aux microtechnologies (« MEMS » par exemple) ; et les matériaux composites comprenant plusieurs de ces matériaux.

Avantageusement, les première et seconde membranes (29, 30) peuvent être en un matériau choisi parmi les matériaux qui résistent à la gravure anisotrope du matériau du substrat, tel que le $Si_3N_4$ ou le $SiO_2$ si le substrat est en Si.

Avantageusement, les moyens de chauffage résistifs (34) peuvent être en un matériau choisi parmi le platine, le tantale, le tungstène, le nitrure de titane, le silicium monocristallin ou polycristallin dopé et de préférence fortement dopé, et de manière générale, tous les matériaux conducteurs compatibles avec les technologies dédiées à la micro-électronique et aux microtechnologies, en d'autres termes, les technologies de micro et de nanofabrication.

Avantageusement, la couche électriquement et thermiquement isolante (36) est en un matériau choisi parmi $SiO_2$, $Si_3N_4$, $Al_2O_3$, $HfO_2$ et tous les matériaux électriquement et thermiquement isolants compatibles avec les technologies de micro et nanofabrication.

Avantageusement, les motifs à imprimer (37) sont en un matériau choisi parmi Si, $SiO_2$, $Si_3N_4$, $Al_2O_3$, et $HfO_2$, et tous les matériaux compatibles avec les technologies de micro et nanofabrication.

L'invention concerne, en outre, un dispositif de lithographie par nano-impression thermique comprenant une chambre d'impression à l'intérieur de laquelle se trouvent :

- un moule selon l'invention tel que décrit dans ce qui précède, comprenant des motifs à imprimer, ledit moule étant supporté par un piston ;

- un support de plaque, éventuellement chauffant, apte à supporter une plaque en polymère ou résine faisant face auxdits motifs à imprimer dudit moule;

- et au moins une source qui émet un champ électromagnétique.

Avantageusement, au moins une source est intégrée dans le piston et/ou au moins une source est intégrée dans le support de plaque, et/ou au moins une source est disposée dans la chambre d'impression à l'extérieur du moule, du piston, et du support de plaque.

L'invention concerne aussi un procédé de fabrication d'un moule selon le premier mode de réalisation de ce moule, tel qu'il a été décrit plus haut, dans lequel on réalise les étapes successives suivantes :

a) on fournit un substrat (21) comportant une première surface principale (22) et une seconde surface principale (23) ;
b) éventuellement, on forme une couche thermiquement conductrice (33) et de support mécanique dans une zone de la seconde surface principale (23) du substrat (21) ;
c) éventuellement, on dépose une première membrane (29) sur ladite première surface principale (22) ;
d) on dépose une seconde membrane électriquement et thermiquement isolante (30) sur ladite seconde surface principale (23) ;
e) on dépose une couche de résistance chauffante et de captage d'une énergie électromagnétique sur une zone de la seconde membrane (30) au-dessus de la couche thermiquement conductrice (33) et de support mécanique ;
f) on met en forme la couche de résistance chauffante et de captage d'une énergie électromagnétique ;
g) on dépose une couche électriquement et thermiquement isolante (36) sur ladite couche de résistance chauffante et de captage d'une énergie électromagnétique mise en forme (34) et sur la seconde membrane (30) ;
h) on réalise des motifs à imprimer (37) sur ladite couche électriquement et thermiquement isolante (36).

L'invention concerne, en outre, un procédé de fabrication d'un moule selon le second mode de réalisation de ce moule, tel qu'il a été décrit plus haut, dans lequel on réalise les étapes successives suivantes:

a) on fournit un substrat (21) comportant une première surface principale (22) et une seconde surface principale (23) ;
b) éventuellement, on forme une couche thermiquement conductrice (33) et de support mécanique dans une zone de la seconde surface principale (23) du substrat (21) ;
c) éventuellement, on dépose une première membrane (29) sur ladite première surface principale (22) ;
d) on dépose une seconde membrane électriquement et thermiquement isolante (30) sur ladite seconde surface principale (23) ;
e) on dépose une couche de résistance chauffante et de captage d'une énergie électromagnétique sur une zone de la seconde membrane (30) au-dessus de la couche thermiquement conductrice (33) et de support mécanique ;
f) on met en forme la couche de résistance chauffante et de captage d'une énergie électromagnétique ;
g) on dépose une couche électriquement et thermiquement isolante (36) sur ladite couche de résistance chauffante et de captage d'une énergie électromagnétique mise en forme (34) et sur la seconde membrane (30) ;
h) on réalise des motifs à imprimer (37) sur ladite couche électriquement et thermiquement isolante (36) ;
i) éventuellement, on grave la première membrane, puis on forme une cavité (24) dans le substrat (21) depuis un premier orifice (27) dans la première surface principale (22) jusqu'à la couche thermiquement conductrice (33) et de support mécanique dans une zone de la seconde surface principale (23) ;

Éventuellement, on réalise des marques d'alignement, positionnement (39, 40), dans la couche de membrane (30) et/ou dans la couche isolante (36) et/ou sur ladite couche électriquement et thermiquement isolante (36) au voisinage des motifs à imprimer (37).

L'invention concerne, enfin, un procédé de préparation d'un substrat comprenant une surface nanostructurée par une technique de lithographie par nanoimpression thermique dans lequel on met en oeuvre le moule tel que précédemment défini.

Un tel procédé se distingue fondamentalement des procédés de l'art antérieur du fait de la mise en oeuvre du moule spécifique selon l'invention et présente tous les avantages liés de manière inhérente à ce moule et dont la plupart ont été mentionnés plus haut.

L'invention sera mieux comprise à la lecture de la description détaillée qui va suivre, faite à titre illustratif et non limitatif, en référence aux dessins joints dans lesquels :

## BRÈVE DESCRIPTION DES DESSINS

- Les Figures 1A à 1F sont des vues schématiques, en coupe verticale, qui illustrent les étapes successives de la fabrication d'un substrat nanostructuré par un procédé de nano-impression thermique ;

- La Figure 2A est une vue schématique, de dessus, d'un moule chauffant selon l'invention, dans le second mode de réalisation de celui-ci ;

- La Figure 2B est une vue schématique, en coupe verticale, d'un moule chauffant selon l'invention, dans le second mode de réalisation de celui-ci ;

- La Figure 3A est une vue schématique, de dessus, d'un moule chauffant selon l'invention dans le second mode de réalisation de celui-ci, comprenant des motifs, marques d'alignement, positionnées, au voisinage des motifs à imprimer ;

- La Figure 3B est une vue schématique, en coupe verticale, d'un moule chauffant selon l'invention, dans le second mode de réalisation de celui-ci comprenant des motifs, marques d'alignement, positionnées, au voisinage des motifs à imprimer ;

- La Figure 3C est une vue schématique en coupe verticale d'un moule chauffant selon l'invention, dans le second mode de réalisation de celui-ci avec une structure comprenant des « mesas », la membrane (30), la couche (36) et aussi éventuellement et de préférence, le substrat ayant été gravé pour présenter une surface non utile en retrait ;

- Les Figures 4A à 4H sont des vues schématiques, en coupe verticale, qui illustrent les étapes successives de la fabrication d'un moule selon l'invention, dans le second mode de réalisation de celui-ci ;

- La Figure 5 est une vue schématique, en coupe verticale, qui montre l'impression d'une ligne (infiniment longue) de largeur 1 sur laquelle on applique une pression p, dans un film d'épaisseur h et de viscosité η ;

- La Figure 6 est une vue schématique, de dessus, des moyens de captage et des moyens de chauffage résistifs d'un moule selon l'invention dans un mode de réalisation où ces moyens sont distincts, séparés, éloignés.

- La Figure 7 est une vue schématique, de dessus, des moyens de captage et des moyens de chauffage résistifs d'un moule selon l'invention dans un mode de réalisation où ces moyens sont confondus.

- La Figure 8 est une vue schématique, en coupe verticale, d'un moule selon l'invention dans lequel les motifs à imprimer qui présentent des tailles croissantes depuis des motifs plus petits à des motifs plus gros sont portés à des températures croissantes T1, T2, et T3.

- La Figure 9 est une vue schématique en coupe verticale d'un moule chauffant selon l'invention, dans le premier mode de réalisation de celui-ci ;

- Les Figures 10A à 10E sont des vues schématiques, en coupe verticale, qui illustrent les étapes successives de la fabrication d'un moule selon l'invention, dans le premier mode de réalisation de celui-ci ;

- Les Figures 11A à 11C sont des vues schématiques en coupe verticale de trois modes de réalisation d'un dispositif de lithographie par nano-impression thermique selon l'invention dans lesquels une source qui émet un champ électromagnétique est respectivement disposée dans le piston (Figure 11A), dans la chambre d'impression (Figure 11B), ou dans le support de plaque à imprimer (Figure 11C).

## EXPOSÉ DÉTAILLÉ DE MODES DE RÉALISATION PARTICULIERS

Précisons tout d'abord que dans l'ensemble de la présente description, les termes tels que « sur », « au-dessus » pour définir la position d'un premier élément du moule par rapport à un second élément ne signifient pas que le premier élément est à une altitude plus élevée que le second élément dans un plan vertical, mais ont plutôt simplement pour but de décrire la position relative, du premier élément par rapport au second élément sans que ces deux éléments se situent forcément dans un plan vertical. Il en est de même pour les termes « sous » et « au-dessous » et pour les termes « supérieur » et « inférieur ».

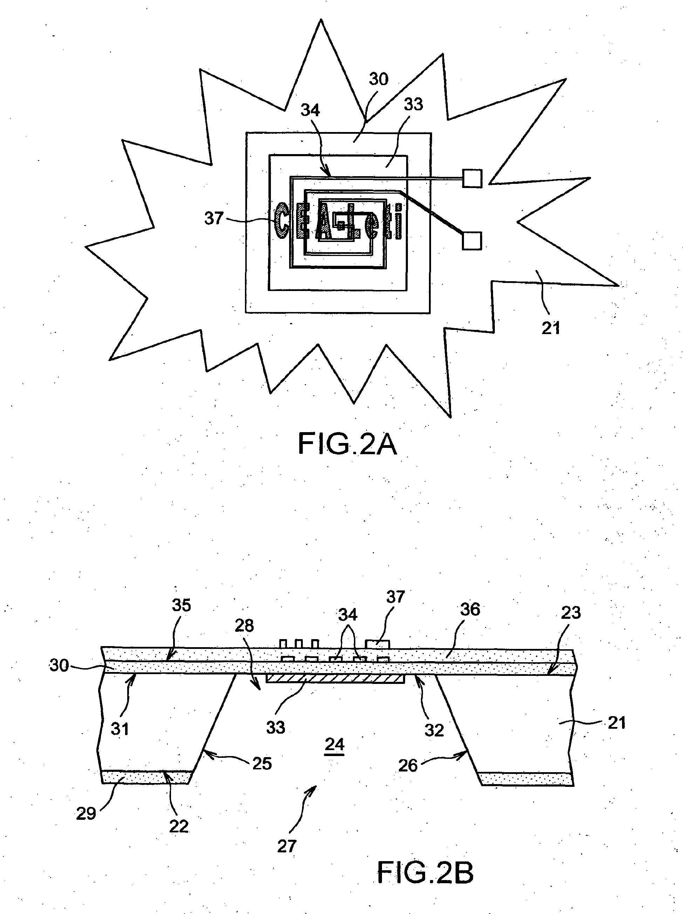

Nous commencerons par décrire, par commodité, le second mode de réalisation du moule selon l'invention qui est représenté sur les Figures 2A et 2B.

Ce moule comprend un substrat (21) comportant une première surface principale (22) et une seconde surface principale (23).

Sur la Figure 2B, les première (22) et seconde 23) surfaces principales sont planes, parallèles et horizontales. La première surface principale (22) peut donc être définie comme une surface inférieure, tandis que la seconde surface principale (23), peut être définie comme une surface supérieure. Il est bien entendu que cette disposition de la première surface principale (22) et de la seconde principale (23) n'est donnée qu'à titre d'exemple et que d'autres dispositions de ces deux surfaces pourraient être envisagées.

Le substrat (21) peut ainsi avoir la forme d'une plaque ou plaquette comprenant deux surfaces planes, parallèles (22, 23), par exemple carrées, rectangulaires ou encore circulaires.

L'épaisseur du substrat (21) c'est-à-dire la distance entre la première surface principale (22) du substrat (21) et la seconde surface principale (23) du substrat (21) est typiquement comprise entre 350 et 735 μm en fonction de l'épaisseur du substrat choisi.

Le substrat (21) peut être en tout matériau compatible avec les procédés de micro et de nanofabrication tel que le silicium, l'oxyde de silicium, le nitrure de silicium, le germanium, le saphir, le GaAs, et les matériaux composites comprenant plusieurs de ces matériaux.

Un matériau préféré est le silicium.

Une cavité traversante (24) définie par des parois latérales (25, 26) s'étend dans le substrat (21) depuis un premier orifice (27) dans la première surface principale (22) jusqu'à un second orifice (28) dans la seconde surface principale (23).

Cette cavité (24) et donc les deux orifices (27, 28) ont généralement une section circulaire ou rectangulaire selon les procédés de fabrication choisis et le second orifice (28) a généralement une taille inférieure ou égale à la taille du premier orifice (27). Par exemple, le second orifice (28) a généralement un diamètre inférieur au diamètre du premier orifice (27) notamment si la gravure est anisotrope et se fait par voie humide.

Comme cela est représenté sur la Figure 2B, la cavité (24) peut ainsi avoir la forme d'un tronc de cône dont les parois latérales (25, 26) convergent depuis la première surface principale (22) jusqu'à la seconde surface principale (23).

Toutefois, le fait que la cavité (24) présente des parois latérales (25, 26) obliques ne présente pas un intérêt particulier et d'autres configurations pourraient être envisagées pour les parois latérales (25, 26) de la cavité (24).

La première surface principale (22) est éventuellement recouverte par une première membrane (29) (sur les figures, il s'agit d'une membrane inférieure).

Cette première membrane (29) lorsqu'elle est présente peut recouvrir en totalité ou en partie la première surface principale (22) du substrat, et peut soit laisser totalement libre le premier orifice (27), soit obturer totalement ou en partie ledit premier orifice.

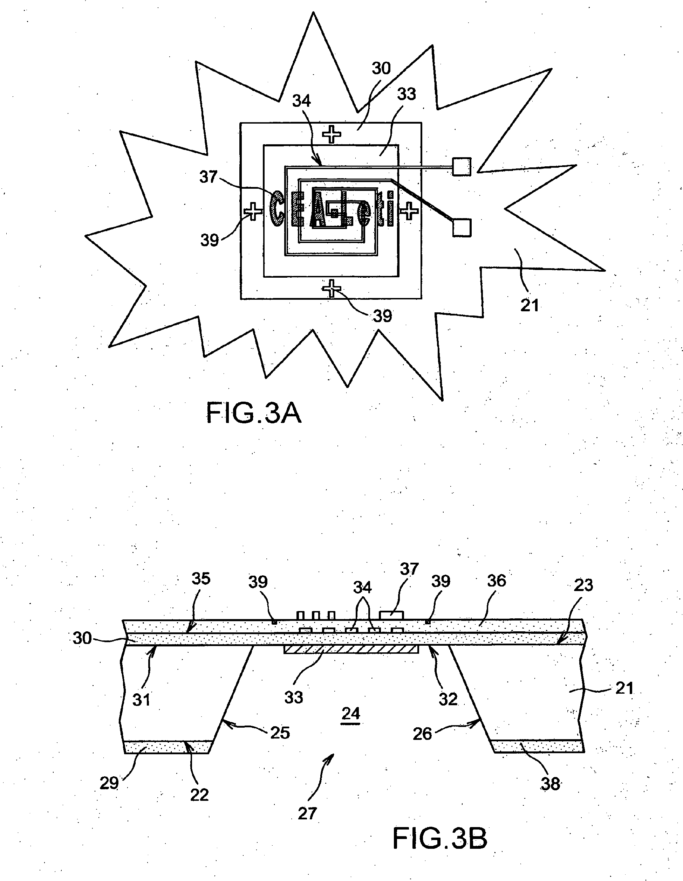

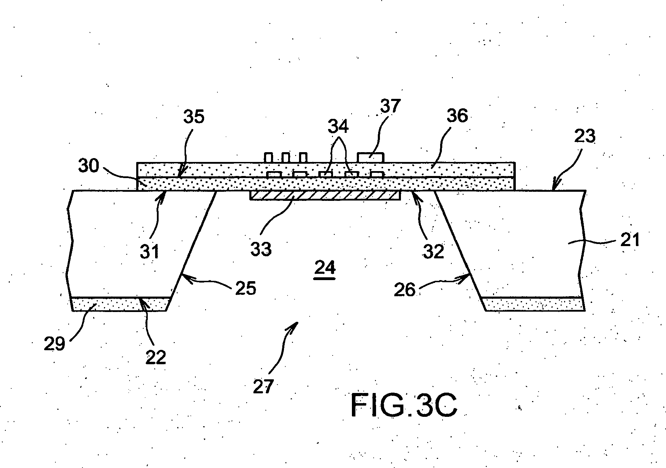

Sur les Figures 2A, 2B, 3A, 3B, 3C à titre d'exemple, on a représenté un mode de réalisation dans lequel la première membrane (29) laisse libre ledit premier orifice (27). En d'autres termes, cette première membrane (29) recouvre en totalité ou en partie ladite première surface (22) mais n'obture pas ledit premier orifice (27) et ne va pas au-delà des bords de celui-ci.

La première membrane (29) n'est pas essentielle, ce n'est pas une membrane à proprement parler mais un masque qui permet de faciliter la gravure du substrat pour avoir l'évidement ou cavité (24) .

La cavité (24) peut, dans le moule selon l'invention, dans ce second mode de réalisation, être définie comme un évidement dans le cas où le premier orifice (27) est laissé libre (comme sur les figures 2B, 3B, 3C) ou est seulement obturé en partie. Mais cette configuration de la cavité (24) sous la forme d'un évidement n'est toutefois pas obligatoire, c'est-à-dire que la cavité (24) peut être fermée de part et d'autre, ce qui est le cas lorsque la membrane (29) couvre, obture totalement le premier orifice (27).

Une configuration de la cavité sous la forme d'un évidement est utile quand il y a des marques d'alignement pour positionner la structure.

On pourrait dans ce cas voir à travers l'évidement lorsqu'on positionne la structure.

Si l'alignement n'existe pas, l'évidement n'est pas pertinent. Dans ce cas, on préfère une cavité (24) fermée, et non un évidement traversant.

Le second orifice (28) est obturé par une seconde membrane (30) (sur les figures 2B, 3B et 3C, il s'agit d'une membrane supérieure) qui repose par une de ses faces (31), à savoir la face inférieure dans le cas de la Figure 2B, sur ladite seconde surface principale (23) du substrat (21).

Cette seconde membrane (30) recouvre en totalité ou en partie ladite seconde surface (23).

La seconde membrane (30) peut être définie comme un support sur lequel est disposée la couche (36) contenant les moyens de chauffage (34) et qui est surmontée par les motifs (37). Cette membrane (30) est électriquement et thermiquement isolante car les éléments chauffants (34), qui doivent généralement être assez proches des motifs (37) sont noyés dans cette membrane (30) et/ou dans la couche (36).

Il est équivalent, aussi bien du point de vue de la fabrication du moule, que du point de vue de son utilisation, que les éléments chauffants (34) soient noyés dans la membrane (30), ou bien que les éléments chauffants soient noyés dans la couche (36).

Un point généralement crucial est que la surface supérieure de la couche (36) soit plane.

Par « assez proches », on entend généralement que les éléments chauffants (34) sont situés généralement à une distance de un à quelques nanomètres (par exemple 2, 3, 5, 10, 20) jusqu'à 100 à quelques centaines de nanomètres (par exemple 200, 300, 500, 1000, 2000 nm) des motifs (37).

Lesdites première et seconde membranes (29, 30) ont généralement une épaisseur de 100 à 200 nm.

Ces première (29) et seconde (30) membranes sont généralement en un matériau choisi parmi les matériaux électriquement et thermiquement isolants qui résistent à la gravure du substrat, en particulier parmi les matériaux qui résistent à la gravure anisotrope du substrat en silicium, tels que $Si_3N_4$ ou $SiO_2$.

Les première (29) et seconde (30) membranes peuvent aussi se présenter sous la forme de plusieurs couches (« multicouche »), chacune de ces couches étant par exemple en un des matériaux précédemment cités.

Il est à noter que la membrane (30) n'est pas forcément utilisée pour arrêter la gravure mais avantageusement, elle peut être utilisée dans ce but.

La partie libre (32) de la face inférieure (31) de ladite seconde membrane (30), du côté du second orifice (28), et qui ne repose donc pas sur la seconde surface principale (23) du substrat (21) comporte éventuellement une couche (33) conductrice thermiquement.

Cette couche (33) est généralement en un matériau choisi parmi Si, les métaux et les semiconducteurs, par exemple la couche (33) peut être en Si ou en TiN. La couche (33) a généralement une épaisseur de 500 nm à 5 $\mu$m.

La couche (33) n'est pas essentielle. La couche (33) est thermiquement conductrice et non isolante pour homogénéiser et distribuer uniformément la chaleur sur toute la surface au-dessous des moyens de chauffage (34).

Il peut être souhaitable de rajouter une couche isolante (non représentée) en-dessous de cette couche (33) pour limiter et même éviter la convexion et pour que la chaleur ne se diffuse pas trop dans le substrat (21).

Cette première couche (33) ne recouvre généralement qu'une fraction de la partie libre (32) de la face inférieure (31) de la seconde membrane (30), et elle est généralement placée au centre de ladite partie libre, et de manière correspondante au centre dudit second orifice (28). En outre, la couche (33), ainsi placée, peut ne recouvrir que certaines zones de la partie libre (32) de la face inférieure de la seconde membrane (30) pour uniformiser la chaleur seulement sur certaines zones de la surface précisément au-dessous des moyens de chauffage.

Des moyens de chauffage (34) sont déposés sur l'autre des faces (35) de ladite seconde membrane (30), dans une zone de ladite seconde membrane (30) au-dessus dudit second orifice (28) de la cavité (24) et au-dessus de ladite première couche éventuelle (33). Ces moyens, éléments de chauffage (34) sont généralement constitués par une couche de résistance chauffante recouvrant au moins en partie ladite zone. Cette couche de résistance chauffante (34) a généralement une épaisseur de 10 à 500 nm.

Cette couche de résistance chauffante présente généralement des motifs, une forme, une géométrie, déterminée dans le plan de la couche et cette couche comporte généralement plusieurs éléments chauffants, de préférence discrets, distincts, séparés.

La position exacte des éléments chauffants résistifs (34), que l'on peut aussi appeler circuits de chauffage ou circuits résistifs, leurs formes, leurs géométries, et leurs dimensions, tailles et leur densité surfacique peuvent être facilement déterminées par l'homme du métier en ayant éventuellement recours à des expériences de simulation.

Les dimensions des éléments chauffants (34) dépendent en particulier des propriétés thermiques des matériaux du moule et du matériau à imprimer tel qu'une résine ainsi que de la température maximale à atteindre et de la densité et de la forme des motifs à imprimer.

Les éléments chauffants (34) peuvent être en un matériau conducteur quelconque, mais des matériaux préférés sont le platine, le tantale, le tungstène, le nitrure de titane, le silicium mono ou polycristallin (dopé) pour leurs propriétés électriques et leur compatibilité avec les technologies de micro et de nanofabrication.

Si une température homogène sur toute la zone de la surface du moule située au-dessus des éléments chauffants, à savoir la région centrale où sont localisés les motifs à imprimer est souhaitée, on peut obtenir une telle température homogène en optimisant la géométrie de l'élément chauffant. La géométrie de l'élément chauffant montrée sur la Figure 2A est un exemple d'une telle géométrie optimisée permettant d'obtenir une température homogène.

Une température homogène est également obtenue ainsi sur toute l'épaisseur de la membrane (30).

Cependant, selon l'invention on cherche plutôt à obtenir une température adaptée, différente pour chacune des différentes zones de la surface du moule qui se trouvent au-dessus des éléments chauffants, ces différentes zones de la surface portant par exemple des motifs à imprimer qui diffèrent par leur taille et/ou leur forme. Plus précisément, on cherche à obtenir une température relativement plus élevée dans les zones de la surface du moule qui portent des motifs à imprimer relativement plus gros ou plus large par rapport aux zones de la surface du moule qui portent des motifs relativement plus petits ou plus fins.

On explique dans ce qui suit les raisons pour lesquelles on dimensionne les éléments chauffants, puis comment on peut dimensionner les éléments chauffants.

La viscosité des matériaux utilisés pour la nano-impression est une propriété thermodépendante, c'est-à-dire que la viscosité ($\eta$) dépend de la température (T).

Pour les matériaux thermoplastiques qui constituent la majorité des matériaux utilisés en nano-impression, la loi dite de WLF (1) décrit correctement cette dépendance :

$$\frac{\eta(T)}{\eta_s} = \exp\left(-c_1 \frac{T - T_s}{c_2 + T - T_s}\right) \quad (1)$$

où $T_s$ = Tg (Température de Transition vitreuse du matériau) + 50K et $\eta_s = \eta(T_s)$, et $c_1$ et $c_2$ sont des variables d'ajustement qui peuvent être déterminées expérimentalement.

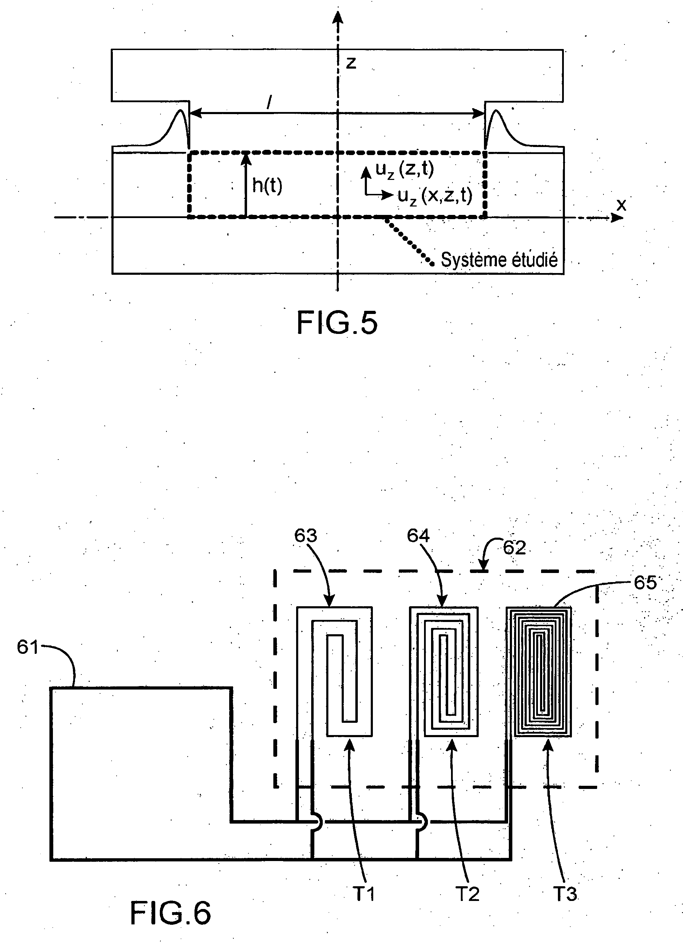

On sait aussi que pour une ligne (infiniment longue) de largeur 1 sur laquelle on applique une pression p selon l'axe z (l'axe z est perpendiculaire à la surface du moule), et que l'on cherche à imprimer dans un film d'épaisseur h et de viscosité $\eta$ (voir figure 5), la vitesse d'enfoncement de cette ligne ($\partial_t h$) est donnée par la relation suivante (2) :

$$\frac{\overline{p}}{l^2} = \eta \cdot \frac{-\partial_t h}{h^3}. \qquad (2)$$

On voit donc que la vitesse d'enfoncement est proportionnelle à 1/ (viscosité x largeur au carré). Par conséquent, si la viscosité est constante dans la résine de motif en motif ce qui est le cas dans la présente, les vitesses d'enfoncement seront très différentes.

En choisissant pour chaque motif la température de ce motif pour laquelle le produit $\eta l^2$ est constant, on obtient une vitesse d'enfoncement des motifs identique quelle que soit leur taille (finesse, largeur). La distribution d'épaisseur résiduelle est alors grandement améliorée.

Le principe du transfert d'énergie par couplage électromagnétique et plus particulièrement par couplage RF, est réglé par la loi de Neumann :

$$R \cdot i = -\frac{d\phi(B)}{dt} \qquad (3)$$

où R est la résistance électrique du conducteur (ici de la boucle de captage), i est le courant et $\phi$ est le flux du champ magnétique *B* traversant la surface délimitée par le conducteur, à savoir les moyens de captage, tels que des circuits ou antennes de captage du moule selon l'invention.

Dans un champ magnétique variable ou électromagnétique, par exemple un champ radiofréquence RF, la puissance W transférée vers un circuit conducteur, tel qu'un élément chauffant, de résistance R est définie par

$$W = \frac{1}{R}\left(\frac{d\phi(B)}{dt}\right)^2 \qquad (4).$$

Cette puissance est fonction de la surface délimitée par le circuit de captage et des caractéristiques (intensité et fréquence) du champ électromagnétique. Pour chaque boucle de captage, la quantité d'énergie puisée est proportionnelle à sa surface.

En conséquence, la température des motifs à imprimer peut facilement être contrôlée localement par un dimensionnement appropriée du circuit, élément de chauffage résistif et du circuit, élément de captage d'un champ électromagnétique, autrement dit de l'antenne de captage, associée à ce circuit, élément résistif.

La fonction de captage du champ et la fonction de chauffage résistif peuvent être séparées et assurées par des éléments différents, distincts, séparés, ou bien ces deux fonctions peuvent être rassemblées, associées dans un seul et même élément, une seule et même structure.

En d'autres termes, le circuit électromagnétique, par exemple le circuit radiofréquence du moule peut être réalisé selon deux configurations :

- Première configuration : le circuit électromagnétique est constitué de moyens de captage comprenant un ou plusieurs élément(s) de captage (donc très peu résistifs), par exemple une ou plusieurs antenne(s) de captage du champ électromagnétique, et des moyens de chauffage séparés, distincts, différents desdits moyens de captage, comprenant un ou plusieurs éléments de chauffage très résistifs, faiblement conducteurs pour dissiper la chaleur aux endroits désirés, chaque élément de captage peut être relié à un seul ou à plusieurs élément (s) de chauffage par l'intermédiaire de moyens d'acheminement de l'énergie captée depuis les moyens de captage jusqu'aux moyens de chauffage résistifs.

On peut avantageusement réaliser un ou plusieurs éléments de captage du champ électromagnétique tels que des antennes, boucles, au même niveau que les éléments, circuits de chauffage, à savoir dans le même plan parallèlement à la surface de l'échantillon, sur la face (35) de la membrane (30).

Ou bien, le ou les élément(s) de captage d'une part et les éléments de chauffage résistifs d'autre part, peuvent être dans deux plans différents, et on peut alors réaliser des circuits métalliques, ou « vias » très peu résistifs pour connecter le ou les éléments, boucles, de captage aux éléments de chauffage, boucles de dissipation.

De tels circuits métalliques ou vias peuvent être réalisés dans le même matériau que les boucles de captage, mais pas forcément. On pourra par exemple choisir pour les vias d'une part et pour les circuits de captage d'autre part, deux métaux avec des résistivités différentes pour que la dissipation de chaleur soit meilleure à proximité des motifs à imprimer.

Généralement, de tels circuits métalliques n'existent pas, dans le cas où les éléments de chauffage et les éléments de captage sont dans le même plan.

Si les éléments chauffants et les éléments de captage ne sont pas dans le même plan, les éléments de chauffage sont généralement situés sur la face (35) de la membrane (30) et les éléments de captage sont généralement situés dans la membrane (30), par exemple sur la face (31) du substrat en-dessous des éléments de chauffage (34) et au-dessus de la couche éventuelle (33).

Cette première configuration permet de découpler captage et zone chauffée et éventuellement de les éloigner si nécessaire.

Les éléments de captage, très peu résistifs, et fortement conducteurs peuvent être en un métal choisi de préférence parmi Cu, Al, Pt, et tous les métaux conducteurs compatibles avec les procédés de micro et nanofabrication.

Les éléments de chauffage, très résistifs et faiblement conducteurs, peuvent être en un matériau choisi parmi le platine, le tantale, le tungstène, le nitrure de titane, le silicium monocristallin ou polycristallin dopé, et de manière générale, tous les matériaux conducteurs compatibles avec les technologies dédiées à la micro-électronique et aux microtechnologies, en d'autres termes, les technologies de micro et de nanofabrication.

- Deuxième configuration : le circuit électromagnétique est uniquement constitué d'éléments de captage tels que des boucles de captage qui sont donc résistives, et ces éléments, tels que des boucles, servent à la fois au captage et à la dissipation d'énergie. C'est-à-dire que les moyens de captage et les moyens de chauffage résistifs sont dans ce cas confondus.

Le terme de boucle est utilisé mais sans que cela ne soit limitatif en aucune manière. Toute géométrie permettant le captage du champ électromagnétique tel qu'un champ RF peut être utilisée.

Ces boucles n'ont pas forcément une forme annulaire, de préférence circulaire et d'autres formes, par exemple polygonales, peuvent être envisagées.

Dans cette deuxième configuration, le matériau qui constitue les moyens de chauffage et les moyens de captage confondus est choisi parmi les matériaux qui constituent les moyens de chauffage déjà cités plus haut.

Cette deuxième configuration est beaucoup plus simple à mettre en oeuvre que la première configuration.

Aussi bien dans la première que dans la seconde configurations, pour jouer sur la résistivité des différents éléments conducteurs formant ainsi la boucle de captage et/ou les éléments dissipateurs, on pourra utiliser des matériaux de résistivité différente (peu résistif pour la boucle de captage et très résistif pour les boucles de dissipation) et/ou optimiser la forme des motifs conducteurs (grosse section pour les lignes conductrices peu résistives et petite section pour les structures plus résistives).

Par exemple, la Figure 6 montre un moule où l'antenne de captage (61) est déportée par rapport à la zone d'impression (62) et l'énergie puisée par l'antenne de captage (61) est transférée à une série de circuits résistifs (63, 64, 65) placés a proximité des motifs à imprimer.

Localement, en fonction des motifs à imprimer, la température du moule peut être contrôlée par la taille, la distance entre les éléments résistifs et le nombre d'éléments résistifs ou par la densité surfacique des éléments résistifs, une densité surfacique plus importante de l'élément résistif donnant une température plus élevée de la zone de surface du moule située au-dessus dudit élément résistif.

Ce contrôle de la température peut être réalisé typiquement par une modélisation aux éléments finis de l'ensemble constitué par le moule, la résine et la plaque qui supporte cette résine. Une telle modélisation permet de calculer localement l'énergie électromagnétique, par exemple l'énergie RF puisée, les flux de chaleur, la température etc.

Ainsi, sur la Figure 6, la température T1 des motifs situés dans la zone de la surface du moule au-dessus des premiers éléments chauffants (63) est inférieure à la température T2 des motifs situés dans la zone au-dessus des deuxièmes éléments chauffants (64) qui est elle-même inférieure à la température T3 des motifs situés dans la zone au-dessus des troisièmes éléments chauffants (65).

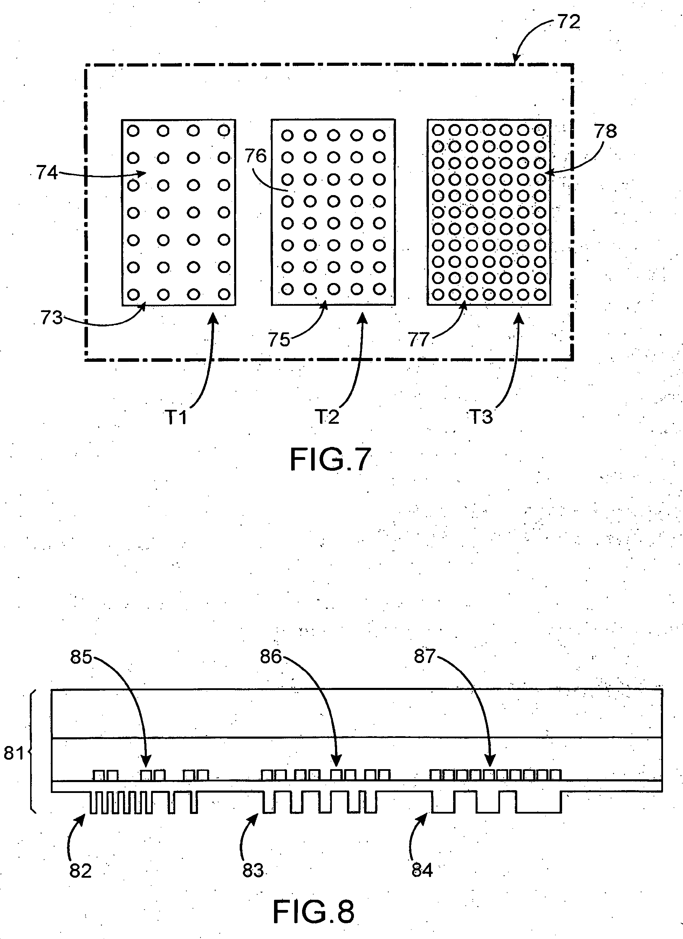

La Figure 7 montre un moule où l'antenne et la résistance chauffante sont rassemblées dans le même élément, qui prend ici la forme d'un anneau résistif (71) de petite dimension dont la taille, définie par le diamètre est généralement de un $\mu$m ou quelques $\mu$m (2, 3, 4, 5 microns) jusqu'à 10 $\mu$m, voire 100 $\mu$m, cet élément étant répété plusieurs fois dans le moule. Localement, la température du moule est ici contrôlée par la densité d'éléments chauffants.

Ainsi sur la Figure 7, tout comme sur la Figure 6, la température T1 des motifs situés dans la zone d'impression (72) dans une zone 1 (73) de surface du moule au-dessus des premiers éléments chauffants (74) est inférieure à la température T2 des motifs situés dans la zone 2 (75) de surface du moule au-dessus des deuxièmes éléments chauffants (76) qui est elle-même inférieure à la température T3 des motifs situés dans la zone 3 (77) au-dessus des troisièmes éléments chauffants (78). En effet, la densité des premiers éléments chauffants situés au-dessous de la zone 1 est inférieure à la densité des deuxièmes éléments chauffants situés au-dessous de la zone 2, qui est elle-même inférieure à la densité des troisièmes éléments chauffants situés au-dessous de la zone 3.

Là-encore, la température peut localement être contrôlée par une modélisation du type mentionné plus haut. Compte tenu que la quantité d'énergie récupérée par les boucles de captage est proportionnelle à la surface couverte par l'ensemble des boucles, localement la température dépend de la densité surfacique et de la taille des boucles.

Dans les deux configurations, les éléments chauffants sont isolés du support par la couche, membrane à faible conductibilité thermique (30) par exemple en $SiO_2$, $Si_3N_4$ ou autre et localement la température peut être rendue plus homogène par la couche conductrice éventuelle (33).

Suivant la densité et la forme des éléments qui vont dissiper l'énergie aux endroits que l'on souhaite chauffer, on va pouvoir ajuster localement l'énergie dissipée, donc la température de chauffe.

Si on prend l'exemple de la Figure 7 ci-dessus, pour les 3 zones considérées (73, 75, 77) (et si on met un matériau thermiquement isolant, par exemple en $SiO_2$ entres ces 3 zones pour limiter la diffusion latérale : couche 36 décrite ci-dessous), on augmente le nombre d'éléments chauffants (qui ont ici la forme de boucles) et on va pouvoir atteindre des températures de chauffe plus élevées depuis la zone 1 (73) jusqu'à la zone 3 (77). Par conséquent, la température dans la zone 3, T3, sera plus élevée que celle dans la zone 2, T2, et que celle dans la zone 1, T1.

Sur la Figure 8, on a représenté en coupe verticale un moule (81) selon l'invention qui porte des motifs à imprimer de tailles différentes (82, 83, 84). Les motifs (82) sont plus petits, plus fins que les motifs (83) eux-mêmes plus petits, plus fins que les motifs (84).

Les motifs (82), (83) et (84) sont situés dans des zones portées respectivement à des températures croissantes T1, T2 et T3 par des éléments chauffants (85, 86, 87) de surface croissante (comme sur la Figure 6) ou de densité croissante (comme sur la Figure 7). En conséquence, les motifs plus gros (84) portés à la température plus élevée T3 diminuent la viscosité du polymère à leur contact qui est ainsi inférieure à la viscosité du polymère en contact avec les motifs (83), elle-même inférieure à la viscosité du polymère en contact avec les motifs (82).

Les éléments chauffants sont disposés à la surface d'un matériau isolant thermiquement, à savoir le matériau de la membrane (30) et sont séparés latéralement les uns des autres par un matériau isolant thermiquement, à savoir le matériau de la couche (36) décrite ci-dessous.

Une couche électriquement et thermiquement isolante (36) recouvre lesdits moyens de chauffage (34) et ladite seconde membrane (30). En d'autres termes, la couche électriquement et thermiquement isolante (36) recouvre lesdits moyens de chauffage (34) dans les parties de la surface (35) de la seconde membrane (30) sur lesquels sont prévus les éléments chauffants (34) ou bien la surface de la seconde membrane (30) dans les parties de la surface (35) de la seconde membrane (30) sur lesquelles ne sont pas prévus d'éléments chauffants (34).

Cette couche (36) sépare aussi latéralement les éléments chauffants (34) les uns des autres.

Cette couche électriquement et thermiquement isolante (36) est généralement en un matériau choisi parmi $SiO_2$, $Si_3N_4$, $Al_2O_3$, et $HfO_2$. Cette couche électriquement et thermiquement isolante (36) a généralement une épaisseur de 10 à 500 nm.

La couche (36) est isolante thermiquement mais les motifs (37) sont quand même chauffés.

En effet, la couche (36) est généralement suffisamment mince (10 à 500 nm) pour permettre que la diffusion thermique arrive verticalement aux motifs, mais cette épaisseur de la couche ne permet pas la diffusion latérale de la chaleur. La majeure partie de la chaleur est donc utilisée pour chauffer les motifs (37) et non le substrat (21).

Le moule selon l'invention comprend des motifs à imprimer (37) sur ladite couche électriquement et thermiquement isolante (36) dans une zone de ladite couche au-dessus de ladite première couche éventuelle (33) et par voie de conséquence, au-dessus dudit second orifice (28) de ladite cavité (24).

Ces motifs (37) du moule sont constitués par une structuration, par exemple par une nanostructuration qui est conforme à la structuration du matériau à imprimer tel qu'une résine organique ou un matériau minéral.

La structuration par exemple la nanostructuration du moule, peut être constituée par un réseau périodique. Ce réseau périodique peut être un réseau à une dimension ou un réseau à deux dimensions.

Un tel réseau à une dimension pourra, par exemple, être un réseau de lignes avec des motifs périodiques d'une période P et d'une hauteur h. La période P peut être de 10 nm à un ou quelques micromètres, de préférence de 100 nm à 1 $\mu$m, de préférence encore de 200 à 600 nm, et la hauteur h peut être d'au moins 5 nm à 500 nm, de préférence de 50 nm à 200 nm.

Si le réseau est un réseau à deux dimensions, il pourra être choisi notamment parmi les réseaux carrés, les réseaux triangulaires, rectangulaires, hexagonaux, et les réseaux plus complexes tels que les réseaux d'Archimède.

Le réseau peut aussi être un réseau de plots.

Il est à noter que la structuration présente généralement des motifs géométriques simples, non arrondis. Par exemple, les lignes peuvent avoir une section transversale triangulaire, rectangulaire ou carrée.

Il est à noter que les moyens de chauffage, éléments chauffants (34) sont généralement assez proches des motifs (37) c'est-à-dire que la distance entre ces moyens de chauffage (34) et ces motifs est généralement dans la plage déjà donnée plus haut, qui peut aller d'un à quelques nanomètres jusqu'à 100 à quelques centaines de nanomètres dans le sens de l'épaisseur.

Avantageusement, comme cela est représenté sur les Figures 3A et 3B, le moule selon l'invention peut comporter des marques, structures de positionnement, d'alignement (39).

Ces marques, structures (39) peuvent avoir la forme d'un carré ou d'une croix ou alors elles peuvent prendre la forme de verniers d'alignement comme ceux utilisés dans la lithographie optique par exemple.

En fait, la forme choisie va dépendre du logiciel et de la reconnaissance d'image qui sera effectuée par la suite, donc cela dépendra des caractéristiques de l'équipement utilisé.

En ce qui concerne le matériau de ces marques de positionnement, et du fait que ces marques n'ont pas obligatoirement besoin de chauffer, on utilisera avantageusement des matériaux compatibles avec les procédés de micro et nanofabrication.

Les Figures 3A et 3B montrent des marques, structures d'alignement qui sont pratiquées dans la couche électriquement et thermiquement isolante (36) au voisinage des motifs à imprimer (37).

Comme cela est montré sur les Figures 3A et 3B, ces marques peuvent être situées généralement à l'extérieur de la zone de la couche isolante (36) sur laquelle se trouvent les motifs à imprimer (37).

Comme cela est montré sur les Figures 3A et 3B, ces marques peuvent se situer en outre généralement au-dessus du second orifice (28) mais non au-dessus de la couche éventuelle (33).

Les marques se trouvent plutôt généralement au-dessus de la fraction de la partie libre (32) de la face inférieure (31) de la seconde membrane (30) qui n'est pas recouverte par la couche optionnelle (33).

Sur la Figure 3C, on montre encore un autre mode de réalisation du moule chauffant selon l'invention, qui est un cas particulier du second mode de réalisation, dans lequel en dehors de la zone fonctionnelle, les couches (30), (36) et aussi éventuellement et de préférence le substrat (21) ont été gravés pour que la surface non utile du substrat soit en retrait (« recess »). On peut aussi dire que l'on fait des « mesas ».

Une telle opération limite la surface de contact de la face avant du moule avec la résine, ce qui réduit les défauts et rend le décollage plus facile. Cette configuration de la Figure 3C peut également faciliter la fixation du moule sur le support de la machine.

Plus précisément, on appelle « zone fonctionnelle » la zone des couches et du substrat qui comprend et/ou supporte les moyens de chauffage, éléments chauffants (34), les moyens de captage, les motifs à imprimer (37), et les marques de positionnement, alignement, éventuelles (39, 40).

Les couches (36) et (30) sont gravées sur toute leur épaisseur et le substrat (21) peut être gravé sur une épaisseur d'une à quelques dizaines de nanomètres (par exemple 20, 30, 40, 50 nm) jusqu'à une à quelques centaines de nanomètres (par exemple 200, 300, 400, 500 nm) (Figure 3C).

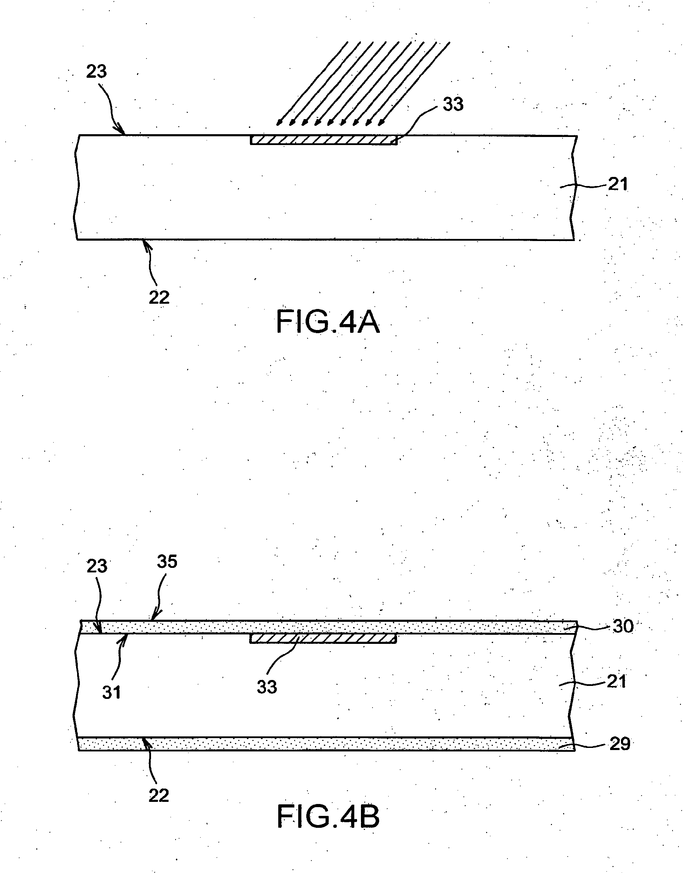

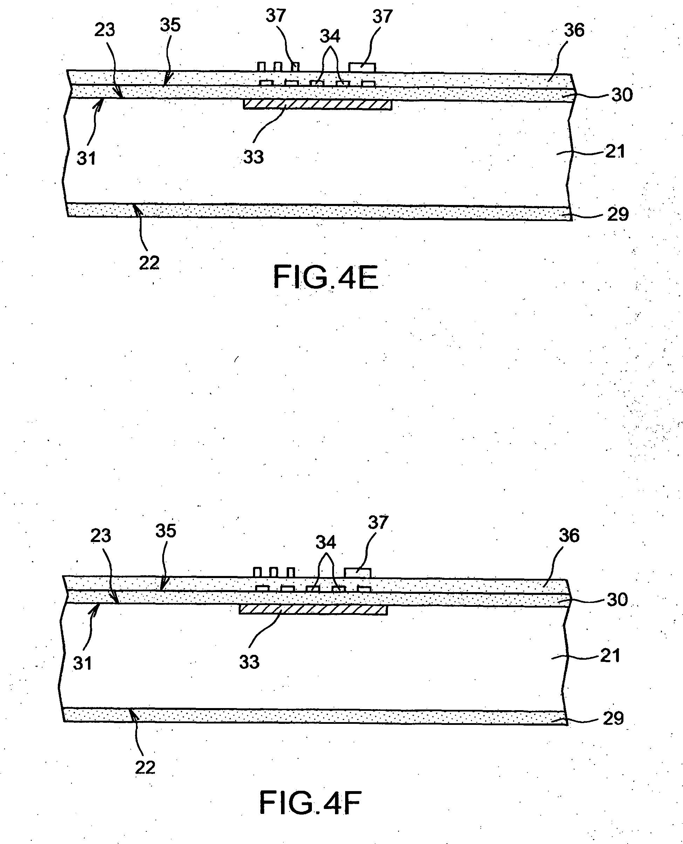

Les différentes étapes d'un procédé pour la fabrication du moule selon l'invention, dans son second mode de réalisation, sont illustrées sur les Figures 4A à 4H.

Dans une première étape, montrée sur la Figure 4A, on prépare sur le substrat (21) dans une zone définie de la seconde surface (qui peut être une surface supérieure) de celui-ci (23), la couche thermiquement conductrice (33) qui servira de support mécanique à la membrane (30), et qui permettra aussi d'uniformiser la température de la zone d'impression.

Cette couche (33) peut être réalisée en effectuant un dopage sélectif du matériau du substrat tel que du silicium, par implantation ionique notamment d'ions $N^+$ puis recuit, ou bien par diffusion. On obtient ainsi par exemple une couche (33) en SiN.

Ces couches fortement dopées ont la propriété de ne pas être attaquées lors de la gravure anisotrope du Si.

Dans une deuxième étape, montrée sur la Figure 4B, on dépose une couche de membrane (29, 30) en un matériau (tel que du $Si_3N_4$) résistant aux gravures anisotropes du matériau du substrat sur la totalité de la surface des deux faces (22, 23) du substrat (21).

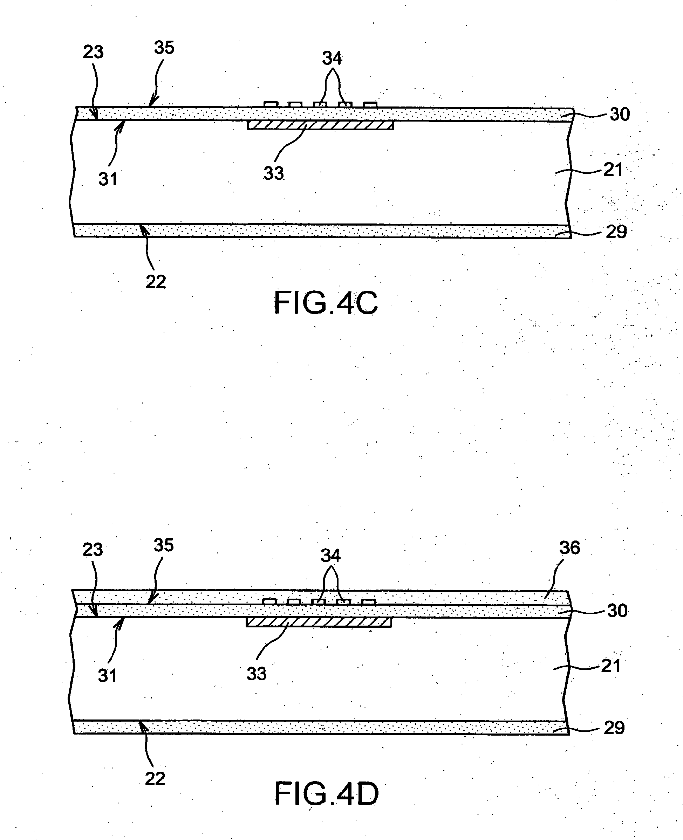

Dans une troisième étape, montrée sur la Figure 4C, on dépose sur la totalité de la surface supérieure (35) de la seconde membrane (supérieure) une couche de résistance chauffante et simultanément une couche de capteur, récepteur de champ électromagnétique, par exemple de radiofréquences (34), par exemple en un métal tel que le platine, en nitrure de titane ou en polysilicium.

On procède ensuite à la mise en forme de la résistance et du récepteur, capteur de champ électromagnétique, par exemple de radiofréquences, par photolithographie et gravure sèche ou humide. Cette mise en forme permet de donner à la résistance la géométrie voulue, éventuellement optimisée, telle que celle montrée (34) sur les Figures 2A et 3A.

Dans une quatrième étape, montrée sur la Figure 4D, on dépose une couche thermiquement et électriquement isolante (36), par exemple en un matériau tel que $SiO_2$, $Si_3N_4$, $Al_2O_3$ ou $HfO_2$ sur les éléments chauffants (34), sur les éléments de captage et sur la seconde couche de membrane (30). Cette couche isolante (36) peut être éventuellement constituée par plusieurs couches, chacune de ces couches étant éventuellement en un matériau différent.

A l'issue du dépôt de la couche isolante (36), on réalise généralement un traitement de planarisation de la couche déposée par polissage chimico-mécanique (CMP).

Dans une cinquième étape, montrée sur la Figure 4E, on réalise les motifs à imprimer (37) (structurations, nanostructurations) sur la couche isolante (36).

Avantageusement, ces motifs (37) sont fabriqués par structuration d'une couche mince par exemple en Si, $SiO_2$, $Si_3N_4$, $Al_2O_3$, $HfO_2$ ou d'une multicouche, généralement par photolithographie et gravure sélective.

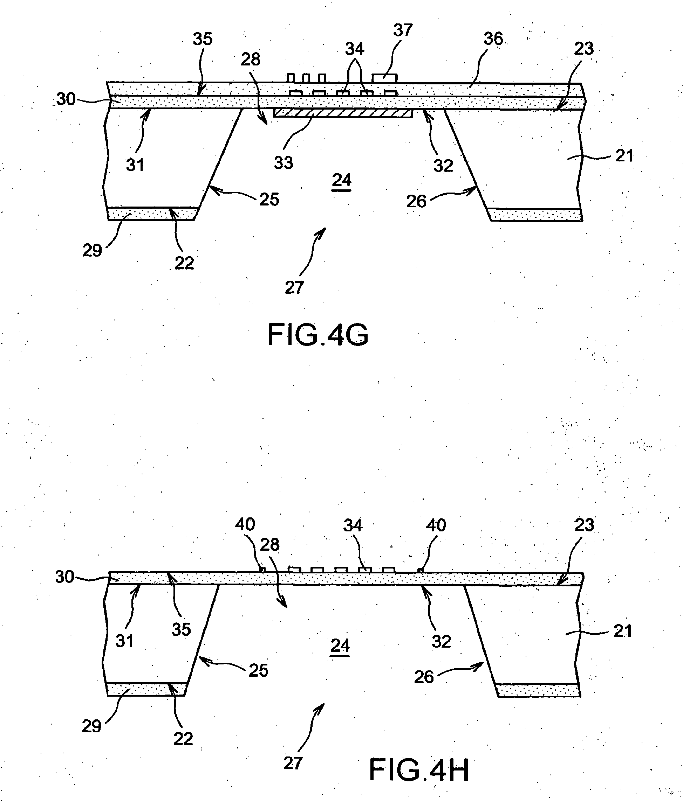

Dans une sixième étape, montrée sur la Figure 4G, la membrane inférieure (29) ou couche de protection, par exemple en $Si_3N_4$, est généralement tout d'abord structurée par lithographie et gravure sèche. Ensuite, on libère la membrane supérieure (30) par gravure anisotrope, par exemple avec de la potasse KOH ou de l'hydroxyde de tétraméthyl ammonium TMAH ou TMAOH, du matériau du substrat (21) depuis la surface inférieure ou face arrière (22) de ce substrat.

Le procédé peut éventuellement comprendre une septième étape si l'on souhaite fabriquer un substrat tel que celui représenté sur les Figures 3A et 3B au cours de laquelle on réalise des marques (39) de positionnement, alignement, par exemple dans la couche isolante (36) au voisinage des motifs à imprimer (37).

De manière générale, les marques (39) peuvent être réalisées à la fin ou en même temps que la réalisation des couches (30), (34) et des motifs (37). Elles peuvent être faites dans la couche (30) ou dans la couche (36) et voire même au niveau des motifs (37) (à condition que la taille de ces marques (39) soit inférieure à la taille des motifs (37)) ; c'est ce mode de réalisation qui est montré sur la Figure 3B.

Les marques peuvent être éventuellement en relief ou de creux, en d'autres termes, les marques peuvent être des bosses ou des trous.

La Figure 4H est une variante de la troisième étape montrée sur la Figure 4C, dans laquelle on réalise une série de marques (40) de positionnement, alignement, sur la couche de membrane supérieure (30) au voisinage des éléments chauffants (34) mis en forme. Ces marques (39, 40) peuvent être ensuite utilisées pour aligner les structures aux niveaux précédents.

Le procédé de fabrication suit ensuite les mêmes étapes que celles décrites précédemment (Figures 4D à 4G).

De manière générale, ces marques (39, 40) peuvent être réalisées durant la mise en forme de la résistance chauffante en structurant la couche conductrice (34) même, mais elles peuvent aussi être superposées sur la surface du moule, généralement sur la couche (36), en déposant une couche opaque, comme par exemple une couche en silicium, qui est ensuite structurée par une étape de lithographie et de gravure sélective pour donner les marques (39, 40).

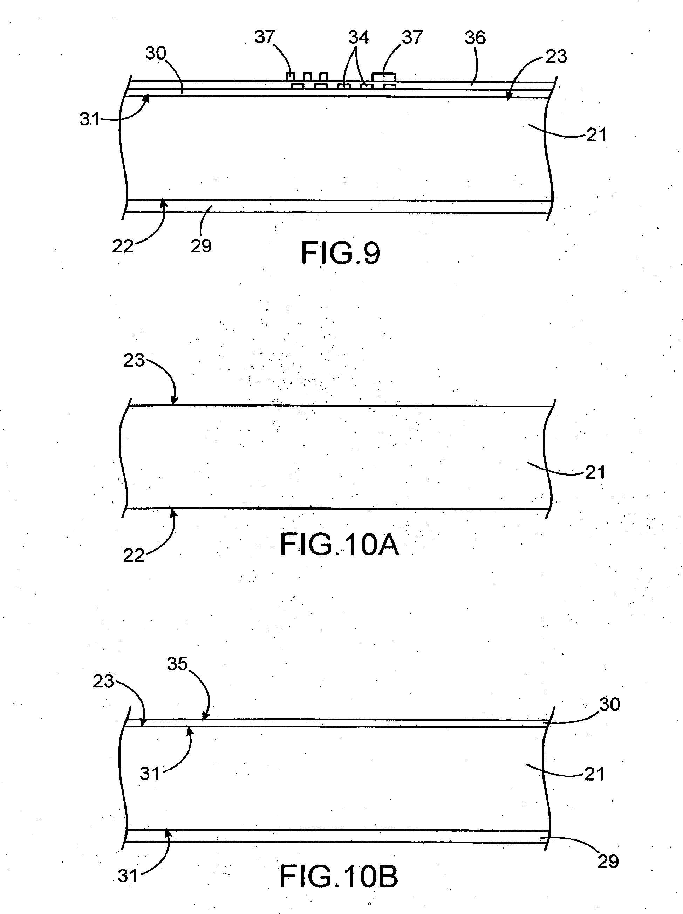

Nous allons maintenant décrire, le premier mode de réalisation du moule selon l'invention qui est représenté sur la Figure 9.

Par soucis de simplification et de cohérence, les mêmes références que celle utilisées sur les figures qui décrivent le second mode de réalisation ont été utilisées sur la Figure 9.

Ce moule comprend un substrat (21) comportant une première surface principale (22) et une seconde surface principale (23).

Sur la Figure 9, les première (22) et seconde (23) surfaces principales sont planes, parallèles et horizontales. La première surface principale (22) peut donc être définie comme une surface inférieure, tandis que la seconde surface principale (23), peut être définie comme une surface supérieure. Il est bien entendu que cette disposition de la première surface principale (22) et de la seconde principale (23) n'est donnée qu'à titre d'exemple et que d'autres dispositions de ces deux surfaces pourraient être envisagées.

Le substrat (21) peut ainsi avoir la forme d'une plaque ou plaquette comprenant deux surfaces planes, parallèles (22, 23), par exemple carrées, rectangulaires ou encore circulaires.

L'épaisseur du substrat (21) c'est-à-dire la distance entre la première surface principale (22) du substrat (21) et la seconde surface principale (23) du substrat (21) est typiquement comprise entre 350 et 735 $\mu$m en fonction de l'épaisseur du substrat choisi.

Le matériau du substrat (21) a déjà été décrit plus haut dans le cadre du second mode de réalisation.

La première surface principale (22) est éventuellement recouverte par une première membrane (29) (sur la Figure 9, il s'agit d'une membrane inférieure).

Cette première membrane (29) lorsqu'elle est présente peut recouvrir en totalité ou en partie la première surface principale (22) du substrat.

La première membrane (29) n'est pas essentielle.

Une seconde membrane (30) (sur la Figure 9, il s'agit d'une membrane supérieure) repose par une de ses faces (31), à savoir la face inférieure dans le cas de la figure 9, sur ladite seconde surface principale (23) du substrat (21).

Cette seconde membrane (30) recouvre en totalité ou en partie ladite seconde surface (23).

La seconde membrane (30) peut être définie comme un support sur lequel est disposée la couche (36) contenant les moyens de chauffage (34) et qui est surmontée par les motifs (37). Cette membrane (30) est électriquement et thermiquement isolante car les éléments chauffants (34), qui doivent généralement être assez proches des motifs (37) sont noyés dans cette membrane (30), et/ou dans la couche (36).

Il est équivalent, aussi bien du point de vue de la fabrication du moule, que du point de vue de son utilisation, que les éléments chauffants (34) soient noyés dans la membrane (30), ou bien que les éléments chauffants soient noyés dans la couche (36).

Un point généralement crucial est que la surface supérieure de la couche (36) soit plane.

Par « assez proches », on entend généralement que les éléments chauffants (34) sont situés généralement à une distance d'un à quelques nanomètres (par exemple 2, 3, 5, 10, 20) jusqu'à 100 à quelques centaines de nanomètres (par exemple 200, 300, 500, 1000, 2000 nm) des motifs (37).

Lesdites première et seconde membranes (29, 30) ont généralement une épaisseur de 100 à 200 nm.

La face inférieure (31) de ladite seconde membrane (30), du côté de la seconde surface principale (23) du substrat (21) comporte éventuellement une couche thermiquement conductrice.

Cette couche (33) est généralement en un matériau choisi parmi Si, les métaux et les semiconducteurs, par exemple la couche (33) peut être en Si ou en TiN. La couche (33) a généralement une épaisseur de 500 nm à 5 $\mu$m.

La couche (33) n'est pas essentielle. La couche (33) est thermiquement conductrice et non isolante pour uniformiser la chaleur sur toute la surface au-dessous des moyens de chauffage (34). Mais il peut être souhaitable de rajouter une couche isolante (non représentée) en-dessous de cette couche (33) et au-dessus du substrat pour éviter la convexion et que la chaleur ne se diffuse trop dans le substrat (21).

Cette première couche (33) ne recouvre généralement qu'une fraction de la face inférieure (31) de la seconde membrane (30), elle est généralement placée au centre de ladite face inférieure, et de manière correspondante aux éléments chauffants et aux motifs.

Des moyens de chauffage (34) sont déposés sur l'autre des faces (35) de ladite membrane (30), dans une zone de ladite seconde membrane au-dessus de ladite première couche éventuelle (33). Ces moyens, éléments de chauffage (34) sont généralement constitués par une couche de résistance chauffante recouvrant au moins en partie ladite zone. Cette couche de résistance chauffante (34) a généralement une épaisseur de 10 à 500 nm.

On pourra pour la description des moyens chauffants se reporter à la description du second mode de réalisation du moule selon l'invention qui a été faite plus haut. En effet, la description des moyens chauffants du premier mode de réalisation du moule s'applique intégralement au second mode de réalisation du moule selon l'invention.

De la même manière, on pourra pour la description des moyens de captage du champ électromagnétique, se reporter à la description du second mode de réalisation du moule selon l'invention qui a été faite plus haut. En effet, la description des moyens de captage du champ magnétique du premier mode de réalisation du moule s'applique intégralement au second mode de réalisation du moule selon l'invention.

Une couche électriquement et thermiquement isolante (36) recouvre lesdits moyens de chauffage (34) et lesdits moyens de captage (si ces moyens de captage se trouvent dans le même plan, que les moyens de chauffage résistifs) et ladite seconde membrane (30). En d'autres termes, la couche électriquement et thermiquement isolante (36) recouvre lesdits moyens de chauffage (34) dans les parties de la surface (35) de la seconde membrane (30) sur lesquels sont prévus les éléments chauffants (34), ou bien la surface de la seconde membrane (30) dans les parties de la surface (35) de la seconde membrane (30) sur lesquelles ne sont pas prévus d'éléments chauffants (34) et d'éléments de captage d'un champ électromagnétique.

Cette couche électriquement et thermiquement isolante (36) est analogue à celle du second mode de réalisation et l'on pourra se reporter à la description qui a déjà été faite plus haut de cette couche.

Le moule selon l'invention dans ce premier mode de réalisation, comprend des motifs à imprimer (37) sur ladite couche électriquement et thermiquement isolante (36) dans une zone de ladite couche au-dessus de ladite première couche éventuelle (33).

Ces motifs (37) sont analogues à ceux du second mode de réalisation et l'on pourra se reporter à la description qui a déjà été faite plus haut de ces motifs.

Avantageusement, le moule selon l'invention peut comporter, dans ce premier mode de réalisation, des marques, structures de positionnement, d'alignement.

Ces marques, structures de positionnement, d'alignement, sont analogues à celles du second mode de réalisation et l'on pourra se reporter à la description qui a déjà été faite plus haut de ces marques, structures de positionnement, d'alignement.

Comme dans le cas particulier du second mode de réalisation, illustré sur la Figure 3C, en dehors de la zone fonctionnelle, les couches (30), (36) et aussi éventuellement et de préférence le substrat (21) peuvent être gravés pour que la surface non utile du substrat soit en retrait (« recess »). On peut aussi dire que l'on fait des « mesas ».

Les différentes étapes d'un procédé pour la fabrication du moule selon l'invention, dans son premier mode de réalisation, sont illustrées sur les Figures 10 A à 10 H.

On peut éventuellement, préalablement à la première étape, réaliser une couche (33) comme sur la Figure 4A.

Dans une première étape, montrée sur la Figure 10B, on dépose une couche de membrane (29, 30) en un matériau (tel que du $Si_3N_4$) résistant aux gravures anisotropes du matériau du substrat sur la totalité de la surface des deux faces (22, 23) du substrat (21).

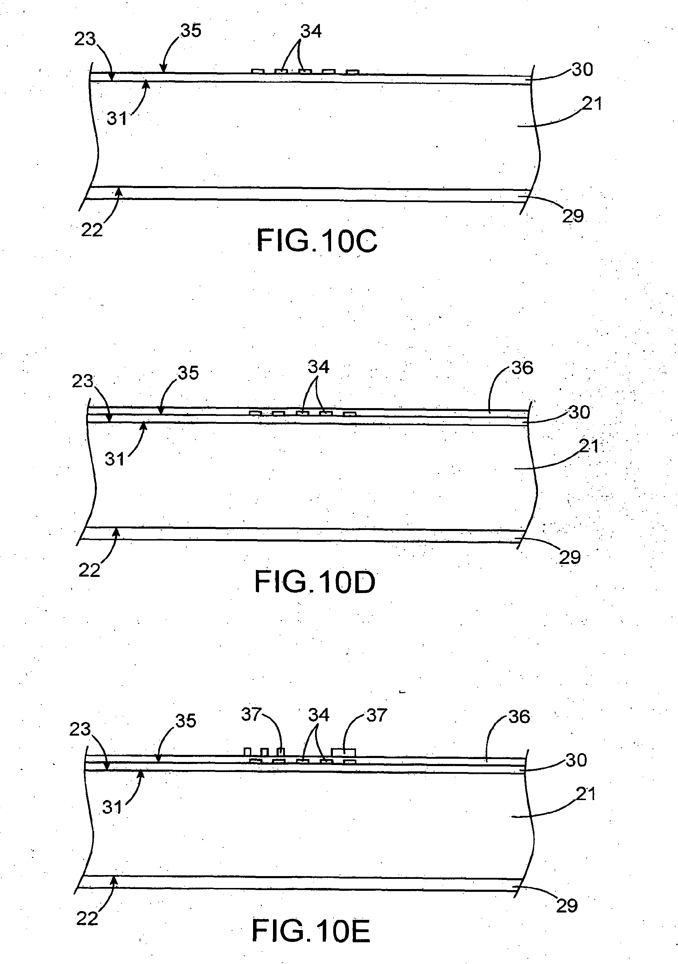

Dans une deuxième étape, montrée sur la figure 10C, on dépose sur la totalité de la surface supérieure (35) de la seconde membrane (supérieure), une couche de résistance chauffante et simultanément une couche de capteur, récepteur de champ électromagnétique, par exemple de radiofréquences (34) par exemple en un métal tel que le platine, en nitrure de titane ou en polysilicium.

On procède ensuite à la mise en forme de la résistance et du récepteur, capteur de champ électromagnétique, par exemple de radiofréquences, par photolithographie et gravure sèche ou humide. Cette mise en forme permet de donner à la résistance la géométrie voulue, éventuellement optimisée, telle que celle montrée (34) sur les Figures 2A et 3A.

Dans une troisième étape, montrée sur la Figure 10D, on dépose une couche thermiquement et électriquement isolante (36), par exemple en un matériau tel que $SiO_2$, $Si_3N_4$, $Al_2O_3$ ou $HfO_2$ sur les éléments chauffants (34), sur les éléments de captage, et sur la seconde couche de membrane (30). Cette couche isolante (36) peut être éventuellement constituée par plusieurs couches, chacune de ces couches étant éventuellement en un matériau différent.

A l'issue du dépôt de la couche isolante (36), on réalise généralement un traitement de planarisation de la couche déposée par polissage chimico-mécanique (CMP).

Dans une quatrième étape, montrée sur la Figure 10E, on réalise les motifs à imprimer (37) (structurations, nanostructurations) sur la couche isolante (36).

Avantageusement, ces motifs (37) sont fabriqués par structuration d'une couche mince par exemple en Si, $SiO_2$, $Si_3N_4$, $Al_2O_3$, $HfO_2$ ou d'une multicouche, généralement par photolithographie et gravure sélective.

Le procédé peut éventuellement comprendre une cinquième étape si l'on souhaite fabriquer un substrat analogue à celui représenté sur les Figures 3A et 3B au cours de laquelle on réalise des marques (39) de positionnement, alignement, par exemple dans la couche isolante (36) au voisinage des motifs à imprimer (37).

On pourra se reporter, pour la description de cette étape de réalisation des marques, à celle qui en est faite plus haut dans le cadre du second mode de réalisation du moule selon l'invention.

L'invention concerne aussi un dispositif de lithographie par nano-impression thermique qui intègre le moule selon l'invention. Le moule selon l'invention peut être intégré dans un dispositif nouveau spécialement conçu pour sa mise en oeuvre mais il peut être facilement intégré dans un dispositif existant même si rien n'est prévu dans de tels dispositifs pour mettre en oeuvre le moule selon l'invention. Il suffira, pour que les dispositifs existants puissent fonctionner avec les moules selon l'invention munis de moyens de captage d'un rayonnement électromagnétique, que ces dispositifs soient pourvus d'au moins une source de rayonnement électromagnétique.

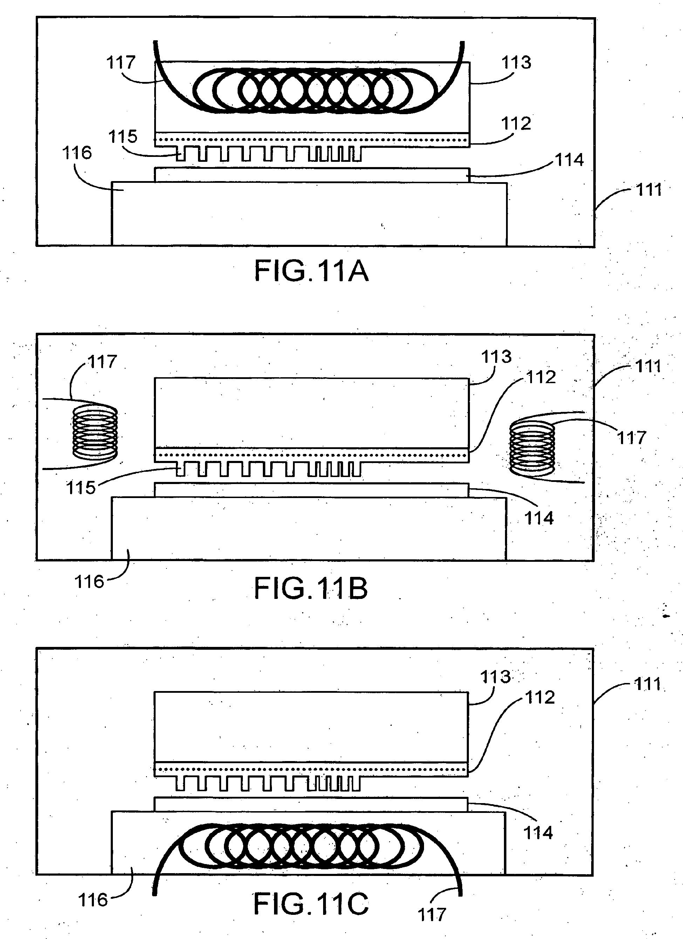

Le dispositif selon l'invention est représenté sur les Figures 11A à 11C.

Ce dispositif comprend une chambre d'impression (111) à l'intérieur de laquelle se trouvent :

- un moule selon l'invention (112) tel que décrit plus haut, comprenant des motifs à imprimer (115), ledit moule étant supporté par un piston (113). L'ensemble du moule avec ses éléments chauffants et le piston forme une tête d'impression ;

- une plaque (114) en polymère ou résine faisant face auxdits motifs à imprimer (115) dudit moule, ladite plaque (114) étant supportée par un support de plaque (116) éventuellement chauffant ;

- et au moins une source (117) qui émet un champ électromagnétique.

La ou les source (s) qui émet (tent) un champ électromagnétique tel qu'une source de radiofréquences, peut (peuvent) être intégrée (s) dans le dispositif de l'invention selon au moins trois modes de réalisation.

Dans un premier mode de réalisation, représenté sur la Figure 11A, une ou plusieurs source(s) (117) est (sont) intégrée (s) dans la tête d'impression, et plus précisément dans le piston qui sert à la mise sous pression.

Dans un deuxième mode de réalisation, représenté sur la Figure 11B, une ou plusieurs source(s) (117) est (sont) disposée(s) à l'intérieur de la chambre d'impression, dans l'espace libre de celle-ci, à l'extérieur de la tête d'impression, du support de plaque et de la plaque. Ainsi, sur la Figure 11B, ont été représentées à titre d'exemple deux sources (117) placées à l'intérieur de la chambre d'impression (111) mais on pourrait placer une seule source ou plusieurs sources l'intérieur de la chambre d'impression (111).

Dans un troisième mode de réalisation, représenté sur la Figure 11C, une ou plusieurs sources (117) est (sont) intégrée(s) dans le support de plaque (116).

Suivant les équipements utilisés et leur complexité, un de ces modes de réalisation ou toute combinaison de deux ou trois de ces modes de réalisation peut être mis en oeuvre.

Le moule selon l'invention peut être utilisé dans un procédé de fabrication d'un substrat comprenant une surface nanostructurée par une technique de lithographie par nano-impression thermique.

Un tel procédé pourra par exemple comprendre les étapes successives suivantes :

a) on dépose une couche d'une résine organique ou d'un matériau minéral à faible température de fusion sur une surface plane d'un substrat ;
b) on chauffe la résine organique jusqu'à une température supérieure ou égale à sa température de transition vitreuse Tg ou à sa température de fusion, ou on chauffe le matériau minéral jusqu'à une température supérieure ou égale à sa température de fusion, et on imprime la couche de résine organique ou de matériau minéral liquide avec le moule selon l'invention présentant une nanostructuration, moyennant quoi la couche de résine organique ou de matériau minéral est munie d'une première nanostructuration conforme à la nanostructuration du moule ;
c) on abaisse la température de la résine organique ou du matériau minéral jusqu'à une température à laquelle il/elle est solide ;
d) on sépare le moule de la couche de résine organique ou de matériau minéral solidaire du substrat.

**Revendications**

1. Moule chauffant pour la lithographie par nano-impression thermique comprenant :

- un substrat (21) comportant une première surface principale (22) et une seconde surface principale (23) de préférence planes et parallèles, ladite première surface principale (22) étant éventuellement au moins en partie recouverte par une première membrane (29), et une seconde membrane électriquement et thermiquement isolante (30) reposant par une première de ses faces (31) sur ladite seconde surface principale (23) et recouvrant au moins en partie ladite seconde surface principale (23) ;
- éventuellement, une couche (33) thermiquement conductrice et de support mécanique de la seconde membrane (30) sur au moins une partie de ladite première face (31) de la seconde membrane (30) et au-dessus dudit substrat;
- éventuellement, une couche isolante sous ladite couche (33) thermiquement conductrice et de support mécanique, ;
- des moyens de chauffage résistifs, (34) sur l'autre des faces (35) de ladite seconde membrane (30) dans une zone de ladite seconde membrane (30) ;
- une couche électriquement et thermiquement isolante (36) qui recouvre lesdits moyens de chauffage (34) et au moins partiellement ladite seconde membrane (30) ;
- des motifs à imprimer (37) sur ladite couche électriquement et thermiquement isolante (36) dans une zone de la surface de ladite couche électriquement et thermiquement isolante (36) au-dessus desdits moyens de chauffage (34) ;
- des moyens de captage pour capter l'énergie électromagnétique d'un champ électromagnétique variable émis par une source située à l'extérieur du moule, lesdits moyens de captage étant reliés auxdits moyens de chauffage résistifs (34) dans lesquels ladite énergie est dissipée.

2. Moule chauffant pour la lithographie par nano-impression thermique comprenant :

- un substrat (21) comportant une première surface principale (22) et une seconde surface principale (23) de préférence planes et parallèles, et une cavité traversante (24) s'étendant depuis un premier orifice (27) dans la première surface principale (22) jusqu'à un second orifice (28) dans la seconde surface principale (23), ladite première surface principale (22) étant éventuellement au moins en partie recouverte par une première membrane (29) obturant totalement ou en partie ou bien laissant libre ledit premier orifice (27), et ledit second orifice (28) étant totalement obturé par une seconde membrane électriquement et thermiquement isolante (30) reposant par une première de ses faces (31) sur ladite seconde surface principale (23) et recouvrant au moins en partie ladite seconde surface (23) ;
- éventuellement, une couche (33) thermiquement conductrice et de support mécanique de la seconde membrane (30) sur ladite première face (31) de la seconde membrane (30) au-dessus (32) dudit second orifice (28) ;
- éventuellement, une couche isolante sous ladite couche (33) thermiquement conductrice et de support mécanique ;
- des moyens de chauffage résistifs (34) sur l'autre des faces (35) de ladite seconde membrane (30) dans une zone de ladite seconde membrane (30) au-dessus dudit second orifice (28) ;
- une couche électriquement et thermiquement isolante (36) qui recouvre lesdits moyens de chauffage (34) et au moins partiellement ladite seconde membrane (30) ;

- des motifs à imprimer (37) sur ladite couche électriquement et thermiquement isolante (36) dans une zone de ladite couche électriquement et thermiquement isolante (36) au-dessus dudit second orifice (28) ;
- des moyens de captage pour capter l'énergie électromagnétique d'un champ électromagnétique variable émis par une source située à l'extérieur du moule, lesdits moyens de captage étant reliés auxdits moyens de chauffage résistifs (34) dans lesquels ladite énergie est dissipée.

3. Moule selon la revendication 1 ou 2, dans lequel lesdites première (22) et seconde (23) surfaces principales sont horizontales.

4. Moule selon l'une quelconque des revendications précédentes, qui comprend en outre des marques de positionnement, alignement (39, 40) ; de préférence lesdites marques d'alignement sont situées dans la seconde couche de membrane (30) et/ou dans la couche électriquement et thermiquement isolante (36) et/ou sur ladite couche électriquement et thermiquement isolante (36) au voisinage desdits motifs à imprimer (37).

5. Moule selon l'une quelconque des revendications précédentes, dans lequel lesdits moyens pour capter l'énergie électromagnétique sont constitués par un ou plusieurs récepteur(s) de radiofréquences ou antenne(s) de captage de radiofréquences ou RF.

6. Moule selon l'une quelconque des revendications précédentes, dans lequel lesdits moyens de chauffage résistifs et lesdits moyens de captage sont distincts et reliés.par des moyens d'acheminement de l'énergie.

7. Moule selon la revendication 6, dans lequel lesdits moyens de captage sont situés dans un même plan que lesdits moyens de chauffage résistifs sur l'autre des faces (35) de ladite seconde membrane (30) et en-dehors de la zone où sont situés lesdits moyens de chauffage résistifs ; ou bien lesdits moyens de captage sont situés dans un plan différent desdits moyens de chauffage résistifs.

8. Moule selon l'une quelconque des revendications 1 à 5, dans lequel lesdits moyens de chauffage résistifs et lesdits moyens de captage sont confondus ; de préférence lesdits moyens de chauffage résistifs et lesdits moyes de captage confondus se présentent sous la forme d'un ou plusieurs motif(s) de chauffage et de captage tels qu'une ou plusieurs boucle(s) de captage résistive(s).

9. Moule selon l'une quelconque des revendications précédentes, dans lequel les moyens de chauffage résistifs, ou les moyens de chauffage résistifs et les moyens de captage confondus comprennent plusieurs éléments chauffants discrets, distincts, séparés les uns des autres par ladite couche électriquement et thermiquement isolante (36) et/ou la seconde membrane (30), et la forme et/ou la taille et/ou la densité desdits éléments chauffants est (sont) choisie(s) de manière à ajuster, régler localement la température de chauffage de la surface de ladite couche (36) et des motifs à imprimer (37) se trouvant sur cette surface.

10. Moule selon la revendication 9, dans lequel les motifs à imprimer comprennent des motifs à imprimer de tailles différentes se trouvant sur des zones différentes de la surface de la couche (36), et la forme et/ou la taille et/ou la densité des éléments chauffants (34) est (sont) choisie(s) de manière à ce que les zones de la surface de la couche (36) sur lesquelles se trouvent des motifs à imprimer de relativement plus grande taille soient chauffées à une température plus élevée que les zones de la surface de la couche (36) sur lesquelles se trouvent des motifs à imprimer de relativement plus petite taille.

11. Moule selon l'une quelconque des revendications 6 à 7, dans lequel lesdits moyens de captage sont en un matériau très peu résistif choisi de préférence parmi Cu, Al, Pt, Ta, TiN, et tous les autres matériaux conducteurs compatibles avec les procédés de micro et nanofabrication.

12. Moule selon l'une quelconque des revendications précédentes, dans lequel le substrat est en un matériau choisi parmi les matériaux compatibles avec les procédés de micro et nanofabrication tels que le silicium, l'oxyde de silicium, le nitrure de silicium, le germanium, le saphir, le GaAs ; et les matériaux composites comprenant plusieurs de ces matériaux.

13. Moule selon l'une quelconque des revendications précédentes, dans lequel les première (29) et seconde (30) membranes sont en un matériau choisi parmi les matériaux qui résistent à la gravure anisotrope du matériau du substrat tels que le $Si_3N_4$ ou le $SiO_2$ si le substrat est en silicium.

14. Moule selon l'une quelconque des revendications précédentes, dans lequel les moyens de chauffage résistifs (34) sont en un matériau choisi parmi le platine, le tantale, le tungstène, le nitrure de titane, le silicium monocristallin ou polycristallin dopé, et tous les matériaux conducteurs compatibles avec les technologies de micro et nanofabrication.

15. Moule selon l'une quelconque des revendications précédentes, dans lequel la couche électriquement et thermiquement isolante (36) est en un matériau choisi parmi $SiO_2$, $Si_3N_4$, $Al_2O_3$, $HfO_2$ et tous les matériaux électriquement et thermiquement isolants compatibles avec les technologies de micro et nanofabrication.

16. Moule selon l'une quelconque des revendications précédentes, dans lequel les motifs à imprimer (37) sont en un matériau choisi parmi Si, $SiO_2$, $Si_3N_4$, $Al_2O_3$, $HfO_2$ et tous les matériaux compatibles avec les technologies de micro et nanofabrication.

17. Dispositif de lithographie par nano-impression thermique comprenant une chambre d'impression (111) à l'intérieur de, laquelle se trouvent :

 - un moule (112) selon l'une quelconque des revendications 1 à 16, comprenant des motifs à imprimer, ledit moule étant supporté par un piston (113) ;
 - un support de plaque (116), éventuellement chauffant, apte à supporter une plaque (114) en polymère ou résine faisant face auxdits motifs à imprimer (115) dudit moule ;
 - et au moins une source (117) qui émet un champ électromagnétique.

18. Dispositif selon la revendication 17, dans lequel au moins une source (117) est intégrée dans le piston (113) et/ou au moins une source (117) est intégrée dans le support de plaque (116), et/ou au moins une source (117) est disposée dans la chambre d'impression (111) à l'extérieur du moule (112), du piston (113), et du support de plaque (116).

19. Procédé de fabrication d'un moule selon la revendication 1, dans lequel on réalise les étapes successives suivantes :

 a) on fournit un substrat (21) comportant une première surface, principale (22) et. une seconde surface principale (23) ;
 b) éventuellement, on forme une couche thermiquement conductrice (33) et de support mécanique dans une zone de la seconde surface principale (23) du substrat (21) ;
 c) éventuellement, on dépose une première membrane (29) sur ladite première surface principale (22) ;
 d) on dépose une seconde membrane électriquement et thermiquement isolante (30) sur ladite seconde surface principale (23) ;
 e) on dépose une couche de résistance chauffante et de captage d'une énergie électromagnétique sur une zone de la seconde membrane (30) au-dessus de la couche thermiquement conductrice (33) et de support mécanique :
 f) on met en forme la couche de résistance chauffante et de captage d'une énergie électromagnétique ;

g) on dépose une couche électriquement et thermiquement isolante (36) sur ladite couche de résistance chauffante et de captage d'une énergie électromagnétique mise en forme (34) et sur la seconde membrane (30) ;

h) on réalise des motifs à imprimer (37) sur ladite couche électriquement et thermiquement isolante (36).

20. Procédé de fabrication d'un moule selon la revendication 2, dans lequel on réalise les étapes successives suivantes :

a) on fournit un substrat (21) comportant une première surface principale (22) et une seconde surface principale (23) ;

b) éventuellement, on forme une couche thermiquement conductrice (33) et de support mécanique dans une zone de la seconde surface principale (23) du substrat (21) ;

c) éventuellement, on dépose une première membrane (29) sur ladite première surface principale (22) ;

d) on dépose une seconde membrane électriquement et thermiquement isolante (30) sur ladite seconde surface principale (23) ;

e) on dépose une couche de résistance chauffante et de captage d'une énergie électromagnétique sur une zone de la seconde membrane (30) au-dessus de la couche thermiquement conductrice (33) et de support mécanique ;

f) on met en forme la couche de résistance chauffante et de captage d'une énergie électromagnétique ;

g) on dépose une couche électriquement et thermiquement isolante (36) sur ladite couche de résistance chauffante et de captage d'une énergie électromagnétique mise en forme (34) et sur la seconde membrane (30) ;

h) on réalise des motifs à imprimer (37) sur' ladite couche électriquement et thermiquement isolante (36) ;

i) éventuellement, on grave la première membrane (29), puis on forme une cavité (24) dans le substrat (21) depuis un premier orifice (27) dans la première surface principale (22) jusqu'à la couche thermiquement conductrice (33) et de support mécanique dans une zone de la seconde surface principale (23).

21. Procédé selon la revendication 19 ou 20, dans lequel on réalise des marques d'alignement, positionnement (39, 40), dans la couche de membrane (30) et/ou dans la couche isolante (36) et/ou sur ladite couche électriquement et thermiquement isolante (36) au voisinage des motifs à imprimer (37).

22. Procédé de préparation d'un substrat comprenant une surface nanostructurée par une technique de lithographie par nano-impression thermique, dans lequel on met en oeuvre le moule selon l'une quelconque des revendications 1 à 16.

**Patentansprüche**

1. Heizform für die thermische Nanoprägelithographie, umfassend :

- ein Substrat (21) mit einer ersten Hauptfläche (22) und einer zweiten Hauptfläche (23), vorzugweise plan und parallel, wobei die genannte erste Hauptfläche (22) eventuell wenigstens teilweise bedeckt ist von einer ersten Membran (29) und eine zweite elektrisch und thermisch isolierende Membran (30) mit einer ersten (31) ihrer Seiten auf der genannten zweiten Hauptfläche (23) ruht und wenigstens teilweise die genannte zweite Hauptfläche (23) bedeckt ;

- eventuell eine thermische leitende und die zweite Membran (30), mechanisch unterstützende Schicht (33) auf wenigstens einen Teil der genannten ersten Seite (31) der zweiten Membran (30) und über dem genannten Substrat ;

- eventuell eine Isolierschicht unter der genannten thermisch leitfähigen und mechanisch unterstützenden Schicht (33) ;

- resistive Heizeinrichtungen (34) auf der anderen Seite (35) der genannten zweiten Membran (30) in einer Zone der genannten zweiten Membran (30) ;

- eine elektrisch und thermisch isolierende Schicht (36), welche die genannten Heizeinrichtungen (34) und wenigstens teilweise die genannte zweite Membran (30) bedeckt ;

- Druckmuster (37), vorgesehen auf der genannten elektrisch und thermisch isolierenden Schicht (36) in einer über den genannten Heizeinrichtungen (34) befindlichen Zone der Oberfläche der genannten elektrisch und thermisch isolierenden Schicht (36) ;

- Empfangseinrichtungen zum Empfangen der elektromagnetischen Energie eines variablen elektromagnetischen Feldes, abgestrahlt von einer außerhalb der Form befindlichen Quelle, wobei die genannten Empfangseinrichtungen mit den genannten resistiven Heizeinrichtungen (34) verbunden sind, in denen die genannte Energie zerstreut wird.

2. Heizform für die thermische Nanoprägelithographie, umfassend :

- ein Substrat (21) mit einer ersten Hauptfläche (22) und einer zweiten Hauptfläche (23), vorzugweise plan und parallel, und einem durchgehenden Hohlraum (24), der sich erstreckt von einer ersten Öffnung (27) in der ersten Hauptfläche (22) bis zu einer zweiten Öffnung (28) in der zweiten Hauptfläche (23), wobei die erste Hauptfläche (22) eventuell wenigstens teilweise bedeckt ist von einer ersten Membran (29), welche die genannte erste Öffnung (27) ganz oder teilweise verschließt oder offen lässt, und die genannte zweite Öffnung (28) ganz von einer elektrisch und thermisch isolierenden zweiten Membran (30) verschlossen wird, die mit einer ersten (31) ihrer Seiten auf der zweiten Hauptfläche (23) ruht und wenigstens teilweise die genannte zweite Hauptfläche (23) bedeckt ;
- eventuell eine thermisch leitende und die zweite Membran (30) mechanisch unterstützende Schicht (33) auf der genannten ersten Seite (31) der zweiten Membran (30) über (32) der genannten zweiten Öffnung (28) ;
- eventuell eine isolierende Schicht unter der genannten thermisch leitenden und mechanisch unterstützenden Schicht (33) ;
- resistive Heizeinrichtungen (34) auf der anderen (35) der Seiten der genannten zweiten Membran (30) in einer über der genannten zweiten Öffnung (28) befindlichen Zone der genannten zweiten Membran (30) ;
- eine elektrisch leitfähige und thermisch isolierende Schicht (36), welche die genannten Heizeinrichtungen (34) und wenigstens teilweise die genannte zweite Membran (30) bedeckt ;
- Druckmuster (37) auf der genannten elektrisch und thermisch isolierenden Schicht (36) in einer über der genannten zweiten Öffnung (34) befindlichen Zone der genannten elektrisch und thermisch isolierenden Schicht (36) ;
- Empfangseinrichtungen zum Empfangen der elektromagnetischen Energie eines variablen elektromagnetischen Feldes, abgestrahlt von einer außerhalb der Form befindlichen Quelle, wobei die genannten Empfangseinrichtungen mit den genannten resistiven Heizeinrichtungen (34) verbunden sind, in denen die genannte Energie zerstreut wird.

3. Form nach Anspruch 1 oder 2, bei der die genannten ersten (22) und zweiten (23) Hauptflächen horizontal sind.

4. Form nach einem der vorhergehenden Ansprüche, die außerdem Positionier-, Ausrichtmarkierungen (39, 40) umfasst ; vorzugsweise befinden sich diese Ausrichtmarkierungen in der zweiten Membranschicht (30) und/oder in der elektrisch und thermisch isolierenden Schicht (36) und/oder auf der genannten elektrisch und thermisch isolierenden Schicht (36) in der Umgebung der genannten Druckmuster (37).

5. Form nach einem der vorhergehenden Ansprüche, bei der die genannten Einrichtungen zum Empfangen der elektromagnetischen Energie gebildet werden durch einen oder mehrere Funkfrequenz-Empfänger oder eine oder mehrere Funkfrequenz-Empfangsantenne(n).

6. Form nach einem der vorhergehenden Ansprüche, bei der die genannten resistiven Heizeinrichtungen und die genannten Empfangseinrichtungen verschieden sind und durch Energieleiteinrichtungen verbunden sind.

7. Form nach Anspruch 6, bei der die genannten Empfangseinrichtungen sich in einer selben Ebene befinden wie die genannten resistiven Heizeinrichtungen auf der anderen (35) der Seiten der genannten zweiten Membran (30), und außerhalb der Zone, in der sich die genannten resistiven Heizeinrichtungen befinden ; oder die genannten Empfangseinrichtungen sich in einer anderen Ebene als die genannten resistiven Heizeinrichtungen befinden.

8. Form nach einem der Ansprüche 1 bis 5, bei der die genannten resistiven Heizeinrichtungen und die genannten Empfangseinrichtungen zusammenfallen ; vorzugweise präsentieren sich die zusammengefallenen resistiven Heizeinrichtungen und Empfangseinrichtungen in Form von einem oder von mehreren Heiz- und Empfangsmustern, zum Beispiel von einer oder mehreren Schleifen.

9. Form nach einem der vorhergehenden Ansprüche, bei der die resistiven Heizeinrichtungen oder die zusammenfallenden resistiven Heizeinrichtungen und Empfangseinrichtungen mehrere unterschiedliche diskrete Heizelemente umfassen, getrennt voneinander durch die genannte elektrisch und thermisch isolierende Schicht (36) und/oder die zweite Membran (30), wobei die Form und/oder die Größe und/oder die Dichte der genannten Heizelemente entsprechend gewählt werden, um die Heiztemperatur der Oberfläche der genannten Schicht (36) und der Druckmuster (37), die sich auf diese Oberfläche befinden, lokal anzupassen, einzustellen.

10. Form nach Anspruch 9, bei der die genannten zu druckenden Muster Druckmuster von unterschiedlicher Größe umfassen, die sich auf verschiedenen Zonen der Oberfläche der Schicht (36) befinden, und die Form und/oder die Größe und/oder die Dichte der Heizelemente (34) so gewählt werden, dass die Zonen der Oberfläche der Schicht (36), auf denen sich relativ größere Druckmuster befinden, mit einer höheren Temperatur beheizt werden als die Zonen der Oberfläche der Schicht (36), auf denen sich relativ kleinere Druckmuster befinden.

**11.** Form nach einem der Ansprüche 6 bis 7, bei der die genannten Empfangseinrichtungen aus einem Material von sehr niedriger Resistivität sind, vorzugsweise ausgewählt unter Cu, Al, Pt, Ta, TiN, und alle anderen leitfähigen Materialien kompatibel mit den Mikro- und Nanofabrikationsverfahren.

**12.** Form nach einem der vorhergehenden Ansprüche, bei der das Substrat aus einem Material ist, das ausgewählt wird unter den mit Mikro- und Nanofabrikationsverfahren kompatiblen Materialien wie etwa Silicium, Siliciumoxid, Siliciumnitrid, Germanium, Saphir, GaAs; und den mehrere dieser Materialien umfassenden Verbundwerkstoffen.

**13.** Form nach einem der vorhergehenden Ansprüche, bei der die erste (29) und die zweite (30) Membran aus einem Material sind, das unter Materialien wie etwa $Si_3N_4$ oder $SiO_2$ ausgewählt wird, die der anisotropen Ätzung des Materials des Substrats widerstehen, wenn das Substrat aus Silicium ist.

**14.** Form nach einem der vorhergehenden Ansprüche, bei der das Material für die resistiven Heizeinrichtungen (34) ausgewählt wird unter Platin, Tantal, Wolfram, Titannitrid, dotiertem monokristallinem oder polykristallinem Silicium und allen leitfähigen, mit den Mikro- und Nanofabrikationstechniken kompatiblen Materialien.

**15.** Form nach einem der vorhergehenden Ansprüche, bei der das Material für die elektrisch und thermisch isolierende Schicht (36) ausgewählt wird unter $SiO_2$, $Si_3N_4$, $Al_2O_3$, $HfO_2$ und allen elektrisch und thermisch isolierenden, mit den Mikro- und Nanofabrikationstechniken kompatiblen Materialien.

**16.** Form nach einem der vorhergehenden Ansprüche, bei der das Material für die zu druckenden Muster (37) ausgewählt wird unter Si, $SiO_2$, $Si_3N_4$, $Al_2O_3$, $HfO_2$ und allen mit den Mikro- und Nanofabrikationstechniken kompatiblen Materialien.

**17.** Vorrichtung für thermische Nanoprägelithographie mit einer Prägekammer (111), in deren Innerem sich befinden :

- eine Form (112) nach einem der Ansprüche 1 bis 16 mit zu prägenden Mustern, wobei die genannte Form von einem Kolben (113) getragen wird ;
- eine Plattenstütze (116), eventuell beheizt, zum Abstützen einer Platte (114) aus Polymer oder Kunstharz, den genannten zu prägenden Mustern (115) der genannten Form gegenüberstehend ;

**18.** Vorrichtung nach Anspruch 17, bei der wenigstens eine Quelle (117) in den Kolben (113) integriert ist und/oder wenigstens eine Quelle (117) in die Plattenstütze (116) integriert ist, und/oder wenigstens eine Quelle (117) in der Prägekammer (111) angeordnet ist, außerhalb der Form (112), des Kolbens (113) und der Plattenstütze (116).

**19.** Verfahren zur Herstellung einer Form nach Anspruch 1, bei dem man die folgenden Schritte ausführt :

a) man bereitet ein Substrat (21) mit einer ersten Hauptfläche (22) und einer zweiten Hauptfläche (23) vor;
b) man bildet eventuell eine thermisch leitfähige und mechanisch unterstützende Schicht (33) in einer Zone der zweiten Hauptfläche (23) des Substrats (21) ;
c) man scheidet eventuell eine erste Membran (29) auf der genannten ersten Hauptfläche (22) ab ;
d) man scheidet eine elektrisch und thermisch isolierende zweite Membran (30) auf der genannten zweiten Hauptfläche (23) ab ;
e) man scheidet eine Schicht mit einem Heizwiderstand und Empfangseinrichtungen einer elektromagnetischen Energie auf einer Zone der zweiten Membran (30) über der thermisch leitfähigen und mechanisch unterstützenden Schicht (33) ab ;
f) man formt die Schicht mit dem Heizwiderstand und den Empfangseinrichtungen von elektromagnetischer Energie ;
g) man scheidet auf der genannten geformten Schicht (34) mit dem Heizwiderstand und den Empfangseinrichtungen einer elektromagnetischen Energie und auf der zweiten Membran (30) eine elektrisch und thermisch isolierende Schicht (36) ab ;
h) man realisiert Prägemuster (37) auf der genannten elektrisch und thermisch isolierenden Schicht (36).

**20.** Verfahren zur Herstellung einer Form nach Anspruch 2, bei dem man die nachfolgenden sukzessiven Schritte realisiert :

a) man bereitet ein Substrat (21) mit einer ersten Hauptfläche (22) und einer zweiten Hauptfläche (23) vor;
b) man bildet eventuell eine thermisch leitfähige und mechanisch unterstützende Schicht (33) in einer Zone der zweiten Hauptfläche (23) des Substrats (21) ;
c) man scheidet eventuell eine erste Membran (29) auf der genannten ersten Hauptfläche (22) ab ;

d) man scheidet eine elektrisch und thermisch isolierende zweite Membran (30) auf der genannten zweiten Hauptfläche (23) ab ;

e) man scheidet eine Schicht mit einem Heizwiderstand und Empfangseinrichtungen einer elektromagnetischen Energie in einer Zone der zweiten Membran (30) über der thermisch leitfähigen und mechanisch unterstützenden Schicht (33) ab ;

f) man formt die Schicht mit dem Heizwiderstand und den Empfangseinrichtungen einer elektromagnetischen Energie;

g) man scheidet auf der genannten geformten Schicht (34) mit dem Heizwiderstand und den Empfangseinrichtungen einer elektromagnetischen Energie und auf der zweiten Membran (30) eine elektrisch und thermisch isolierende Schicht (36) ab ;

h) man realisiert Prägemuster (37) auf der genannten elektrisch und thermisch isolierenden Schicht (36);

i) eventuell ätzt man die erste Membran (29), bildet dann einen Hohlraum (24) in dem Substrat (21), ausgehend von einer ersten Öffnung (27) in der ersten Hauptfläche (22) bis zu der thermisch leitenden und mechanisch unterstützenden Schicht (33) in einer Zone der zweiten Hauptfläche (23).

21. Verfahren nach Anspruch 19 oder 20, bei dem man Ausricht-, Positioniermarkierungen (39, 40) in der Membranschicht (30) und/oder in der isolierenden Schicht (36) und/oder auf der genannten elektrisch und thermisch isolierenden Schicht (36) auf der Umgebung der zu prägenden Muster (37) realisiert.

22. Verfahren zur Vorbereitung bzw. Herstellung eines Substrats mit einer durch eine thermische Nanoprägelithographie-Technik nanostrukturierten Oberfläche, in dem man die Form nach einem der Ansprüche 1 bis 16 umsetzt.

**Claims**

1. A heating mold for thermal nanoimprint lithography comprising:

   - a substrate (21) including a first main surface (22) and a second main surface (23), said first main surface (22) optionally being at least partly covered by a first membrane (29) and a second electrically and thermally insulating membrane (30) lying through a first of its sides (31) on said second main surface (23) and covering at least partly said second main surface (23);

   - optionally, a thermally conducting layer (33) for mechanically supporting the second membrane (30) on at least one portion of said first side (31) of the second membrane (30) and above said substrate;

   - optionally, an insulating layer under said thermally conducting layer and mechanically supporting layer (33);

   - resistive heating means (34) on the other one of the sides (35) of said second membrane (30) in an area of said second membrane (30);

   - an electrically and thermally insulating layer (36) which covers said heating means (34) and at least partly said second membrane (30);

   - patterns to be printed (37) on said electrically and thermally insulating layer (36) in an area of the surface of said electrically and thermally insulated layer (36) above said heating means (34);

   - collecting means for collecting the electromagnetic energy of a variable electromagnetic field emitted by a source located outside the mold, said collecting means being connected to said resistive heating means (34) in which said energy is dissipated.

2. A heating mold for thermal nanoimprint lithography comprising:

   - a substrate (21) including a first main surface (22) and a second main surface (23) preferably planar and parallel, and a through-cavity (24) extending from a first orifice (27) in the first main surface (22) as far as a second orifice (28) in the second main surface (23), said first main surface (22) optionally being at least partly covered by a first membrane (29) totally or partly obturating or else leaving said first orifice (27) clear, and said second orifice (28) being totally obturated by a second electrically and thermally insulating membrane (30) lying through a first of its sides (31) on said second main surface (23) and covering at least partly said second surface (23);

   - optionally, a thermally conducting layer (33) for mechanically supporting the second membrane (30) on said first side (31) of the second membrane (30) above (32) said second orifice (28);

   - optionally, an insulating layer under said thermally conducting and mechanically supporting layer (33);

   - resistive heating means (34) on the other of the sides (35) of said second membrane (30) in an area of said second membrane (30) above said second orifice (28);

   - an electrically and thermally insulating layer (36) which covers said heating means (34) and at least partly said second membrane (30);

- patterns to be printed (37) on said electrically and thermally insulating layer (36) in an area of said electrically and thermally insulating layer (36) above said second orifice (28);
- collecting means for collecting the electromagnetic energy of a variable electromagnetic field emitted by a source located outside the mold, said collecting means being connected to said resistive heating means (34) in which said energy is dissipated.

3. The mold according to claim 1 or 2, wherein said first (22) and second (23) main surfaces are horizontal.

4. The mold according to any one of the preceding claims, which further comprises positioning, alignment marks (39, 40); preferably said alignment marks are located in the second membrane layer (30) and/or in the electrically and thermally insulating layer (36) and/or on said electrically and thermally insulating layer (36) in the vicinity of said patterns to be printed (37).

5. The mold according to any one of the preceding claims, wherein said means for collecting the electromagnetic energy consist in one or several radiofrequencies receiver(s) or antenna(s) for collecting radio frequencies or RF.

6. The mold according to any one of the preceding claims, wherein said resistive heating means and said collecting means are distinct and connected through means for conveying energy.

7. The mold according to claim 6, wherein said collecting means are located in a same plane as said resistive heating means on the other of the sides (35) of said second membrane (30) and outside the area where said resistive heating means are located; or else said collecting means are located in a plane different from said resistive heating means.

8. The mold according to any one of claims 1 to 10, wherein said resistive heating means and said collecting means are merged; preferably said merged resistive heating means and collecting means appear as one or more heating and collecting pattern(s) such as one or several resistive collecting loop(s).

9. The mold according to any one of the preceding claims, wherein the resistive heating means, or the merged resistive heating means and collecting means comprise several discrete, distinct heating elements separated from each other by said electrically and thermally insulating layer (36) and/or the second membrane (30), and the shape and/or the size and/or the density of said heating elements is (are) selected so as to locally adjust, set the heating temperature of the surface of said layer (36) and of the patterns to be printed (37) located on this surface.

10. The mold according to claim 9, wherein the patterns to be printed comprise patterns to be printed of different sizes located on different areas of the surface of the layer (36), and the shape and/or the size and/or the density of the heating elements (34) is (are) selected so that the areas of the surface of the layer (36) on which are located patterns to be printed of a relatively larger size, are heated to a higher temperature than the areas of the surface of the layer (36) on which are located patterns to be printed of relatively smaller size.

11. The mold according to any one of claims 6 to 7, wherein said collecting means are made of a material having a very low resistivity preferably selected from Cu, Al, Pt, Ta, TiN, and all the other conducting materials compatible with micro- and nano-manufacturing processes.

12. The mold according to any one of the preceding claims, wherein the substrate is made of a material selected from materials compatible with micro- and nano-manufacturing processes, such as silicon, silicon oxide, silicon nitride, germanium, sapphire, GaAs; and composite materials comprising several of these materials.

13. The mold according to any one of the preceding claims, wherein the first (29) and second (30) membranes are made of a material selected from materials which withstand anisotropic etching of the substrate material such as $Si_3N_4$ or $SiO_2$, if the substrate is made of silicon.

14. The mold according to any one of the preceding claims, wherein the resistive heating means (34) are made of a material selected from platinum, tantalum, tungsten, titanium nitride, doped monocrystalline or polycrystalline silicon and all the conducting materials compatible with micro- and nano-manufacturing technologies.

15. The mold according to any one of the preceding claims, wherein the electrically and thermally insulating layer (36) is made of a material selected from $SiO_2$, $Si_3N_4$, $Al_2O_3$, $HfO_2$ and all the electrically and thermally insulating materials compatible with micro- and nano-manufacturing technologies.

16. The mold according to any one of the preceding claims, wherein the patterns to be printed (37) are made of a material selected from Si, $SiO_2$, $Si_3N_4$, $Al_2O_3$, $HfO_2$ and all the materials compatible with micro- and nano-manufacturing technologies.

**17.** A device for thermal nanoimprint lithography comprising a printing chamber (111) inside which are located:

- a mold (112) according to any one of claims 1 to 16, comprising patterns to be printed, said mold being supported by a piston (113);
- an, optionally heating, plate support (116), capable of supporting a plate (114) made of a polymer or a resin facing said patterns to be printed (115) of said mold;
- and at least one source (117) which emits an electromagnetic field.

**18.** The device according to claim 17, wherein at least one source (117) is integrated into the piston (113) and/or at least one source (117) is integrated into the plate support (116), and/or at least one source (117) is positioned in the printing chamber (111) outside the mold (112), the piston (113) and the plate support (116).

**19.** A method for manufacturing a mold according to claim 1, wherein the following successive steps are carried out:

a) a substrate (21) is provided, including a first main surface (22) and a second main surface (23);
b) optionally, a thermally conducting and mechanically supporting layer (33) is formed in an area of the second main surface (23) of the substrate (21);
c) optionally, a first membrane (29) is deposited on said first main surface (22);
d) a second electrically and thermally insulating membrane (30) is deposited on said second main surface (23);
e) a resistive heating and electromagnetic energy collecting layer is deposited on an area of the second membrane (30) above the thermally conducting and mechanically supporting layer (33);
f) the resistive heating and electromagnetic energy collecting layer is shaped;
g) an electrically and thermally insulating layer (36) is deposited on said shaped resistive heating and electromagnetic energy collecting layer (34) and on the second membrane (30);
h) patterns to be printed (37) are made on said electrically and thermally insulating layer (36).

**20.** The method for manufacturing a mold according to claim 2, wherein the following successive steps are carried out:

a) a substrate (21) is provided, including a first main surface (22) and a second main surface (23);
b) optionally, a thermally conducting (33) and mechanically supporting layer is formed in an area of the second main surface (23) of the substrate (21);
c) optionally, a first membrane (29) is deposited on said first main surface (22):
d) a second electrically and thermally insulating membrane (30) is deposited on said second main surface (23);
e) a resistive heating and electromagnetic energy collecting layer is deposited on an area of the second membrane (30) above the thermally conducting (33) and mechanically supporting layer;
f) the resistive heating and electromagnetic energy collecting layer is shaped;
g) an electrically and thermally insulating layer (36) is deposited on said shaped resistive heating and electromagnetic energy collecting layer (34) and on the second membrane (30);
h) patterns to be printed (37) are made on said electrically and thermally insulating layer (36);
i) optionally, the first membrane (29) is etched and then a cavity (24) is formed in the substrate (21) from a first orifice (27) in the first main surface (22) as far as the thermally conducting and mechanically supporting layer (33) in an area of the second main surface (23).

**21.** The method according to claim 19 or 20, wherein alignment, positioning (39, 40) marks are made in the membrane layer (30) and/or in the insulating layer (36) and/or on said electrically and thermally insulating layer (36) in the vicinity of the patterns to be printed (37).

**22.** A method for preparing a substrate comprising a nanostructured surface by a thermal nanoimprint lithography technique, wherein the mold according to any one of claims 1 to 16 is applied.

FIG.1A

FIG.1B

FIG.1C

FIG.1D

FIG.1E

FIG.1F

FIG.2A

FIG.2B

FIG.3A

FIG.3B

FIG.3C

FIG.4A

FIG.4B

FIG.4C

FIG.4D

FIG.4E

FIG.4F

FIG.4G

FIG.4H

FIG.5

FIG.6

FIG.7

FIG.8

**FIG.9**

**FIG.10A**

**FIG.10B**

23    35        34                           30
                                             21
31

22                                           29

**FIG.10C**

23      35        34            36
                               30
                               21
31

22                                           29

**FIG.10D**

23      35    37  34  37        36
                               30
                               21
31

22                                           29

**FIG.10E**

FIG.11A

FIG.11B

FIG.11C

**EP 2 426 556 B1**

**Documents brevets cités dans la description**

- WO 2004058479 A

- WO 2004114017 A1